# EUROPEAN PATENT APPLICATION

(11) **EP 4 769 403 A1**
(43) Date of publication of application: **01.07.2026**
(21) Application number: 25210740.4
(22) Date of filing: 23.10.2025
(51) Int. Cl.: G11C 7/10, G11C 7/22, G11C 11/4076, G11C 11/4093, G11C 11/4096

(54) **MEMORY DEVICE**

(30) Priority: 26.12.2024 KR 20240197779
(71) Applicant: SK hynix Inc., Bubal-eub Icheon-si Gyeonggi-do 17336 (KR)
(72) Inventor: KA, Dong Yoon, 17336 Icheon-si, Gyeonggi-do (KR); PARK, Min Cheol, 17336 Icheon-si, Gyeonggi-do (KR)
(74) Representative: Isarpatent

(57) **Abstract**

A memory device includes a first control circuit that is adjacent to a data input and output circuit and that generates an output enable signal driven to a first internal voltage based on an output control pulse generated after the start of a data output operation, generates output data from internal data loaded onto a global line through a repeater by receiving a delay output enable signal driven to a second internal voltage, and outputs the output data to the data input and output circuit, a data storage circuit that is adjacent to the first control circuit and that outputs the internal data to the global line after the start of the data output operation, and a second control circuit that is adjacent to the data storage circuit and that generates the delay output enable signal based on the output enable signal after the start of the data output operation.

## Description

### CROSS-REFERENCE TO RELATED APPLICATION

This application claims priority under 35 U.S.C. §119(a) to Korean Patent Application No. 10-2024-0197779, filed in the Korean Intellectual Property Office on December 26, 2024, the entire contents of which are incorporated herein by reference.

### BACKGROUND

The present disclosure relates to a memory device that compensates for a delay due to a an aggregate distance traveled by enable signals that activate a repeater and a voltage difference between heterogeneous power supplies.

In general, a memory device including double data rate synchronous DRAM (DDR SDRAM) performs read and write operations for data based on a command that is input from an external chip set. In order for the memory device to perform such read and write operations, various circuits need to be included in the memory device. Among the various circuits, a plurality of repeaters that outputs data loaded onto an input and output line to an external device is included in the memory device. In general, the plurality of repeaters is disposed in the middle of the long input and output line and drives and outputs data.

An enable signal that activates the repeater is generated by compensating for an aggregate distance of distances that outputted data travel. If heterogeneous power supplies are used in a memory device, there is a need for a method of compensating for a voltage difference between the heterogeneous power supplies.

### SUMMARY

In an embodiment, a memory device may include a first control circuit disposed to be adjacent to a data input and output circuit, configured to generate an output enable signal that is driven to a first internal voltage based on an output control pulse that is generated after the start of a data output operation, configured to generate output data from internal data loaded onto a global line through a repeater by receiving a delay output enable signal that is driven to a second internal voltage, and configured to output the output data to the data input and output circuit, a data storage circuit disposed to be adjacent to the first control circuit and configured to output the internal data to the global line after the start of the data output operation, and a second control circuit disposed to be adjacent to the data storage circuit and configured to generate the delay output enable signal based on the output enable signal after the start of the data output operation.

In an embodiment, a memory device may include a first control circuit disposed to be adjacent to a data input and output circuit and configured to generate a rising output enable signal and a falling output enable signal that are driven to a first internal voltage by sensing an edge at which a level of an output control pulse that is generated after the start of a data output operation transitions, configured to receive a rising delay output enable signal and a falling delay output enable signal that are driven to a second internal voltage, configured to generate output data from internal data loaded onto a global line through a repeater, and configured to output the output data to the data input and output circuit, a data storage circuit disposed to be adjacent to the first control circuit and configured to output the internal data to the global line after the start of the data output operation, and a second control circuit disposed to be adjacent to the data storage circuit and configured to generate the rising delay output enable signal and the falling delay output enable signal based on the rising output enable signal and the falling output enable signal after the start of the data output operation.

In an embodiment, a memory device may include a first control circuit disposed to be adjacent to a data input and output circuit and configured to generate an even output enable signal and an odd output enable signal that are driven to a first internal voltage based on an output control pulse that is generated after the start of first and second data output operations that are consecutively performed, configured to receive an even delay output enable signal and an odd delay output enable signal that are driven to a second internal voltage, configured to sequentially generate first and second output data from first and second internal data loaded onto a global line through a repeater, and configured to output the first and second output data to the data input and output circuit, a data storage circuit disposed to be adjacent to the first control circuit and configured to output the internal data to the global line after the start of the data output operation, and a second control circuit disposed to be adjacent to the data storage circuit and configured to generate the even delay output enable signal based on the even output enable signal after the start of the first data output operation and configured to generate the odd delay output enable signal based on the odd output enable signal after the start of the second data output operation.

### BRIEF DESCRIPTION OF THE DRAWINGS

FIG. 1 is a block diagram of a semiconductor system according to an embodiment of the present disclosure.
FIG. 2 is a block diagram illustrating an example of a memory device included in the semiconductor system.
FIG. 3 is a block diagram illustrating an example of a first control circuit included in the memory device.
FIG. 4 is a circuit diagram illustrating an example of a first data receiver included in the first control circuit.
FIG. 5 is a block diagram illustrating an example of a second control circuit included in the memory device.
FIG. 6 is a timing diagram for describing an operation of the memory device according to an embodiment of the present disclosure.
FIG. 7 is a block diagram illustrating an example of the memory device included in the semiconductor system.
FIG. 8 is a block diagram illustrating an example of a first control circuit included in the memory device.
FIG. 9 is a circuit diagram illustrating an example of a first data receiver included in the first control circuit.
FIG. 10 is a block diagram illustrating an example of a second control circuit included in the memory device.
FIGS. 11 and 12 are timing diagrams for describing an operation of the memory device according to an embodiment of the present disclosure.
FIG. 13 is a block diagram illustrating an example of a memory device included in the semiconductor system.
FIG. 14 is a block diagram illustrating an example of a first control circuit included in the memory device.
FIG. 15 is a block diagram illustrating an example of an edge sensing circuit included in the first control circuit.
FIG. 16 is a circuit diagram illustrating an example of an even output enable signal generation circuit and an odd output enable signal generation circuit that are included in an output enable signal generation circuit.
FIG. 17 is a circuit diagram illustrating an example of a first data receiver included in the first control circuit.
FIG. 18 is a diagram illustrating an example of a repeater enable signal generation circuit included in the first control circuit.
FIG. 19 is a block diagram illustrating an example of a second control circuit included in the memory device.
FIG. 20 is a circuit diagram illustrating an example of an internal pulse generation circuit included in the second control circuit.
FIGS. 21 and 22 are timing diagrams for describing an operation of the memory device according to an embodiment of the present disclosure.

### DETAILED DESCRIPTION

In the descriptions of the following embodiments, the term "preset" indicates that the numerical value of a parameter is previously decided, when the parameter is used in a process or algorithm. According to an embodiment, the numerical value of the parameter may be set when the process or algorithm is started or while the process or algorithm is performed.

Terms such as "first" and "second," which are used to distinguish among various components, are not limited by the components. For example, a first component may be referred to as a second component, and vice versa.

When one component is referred to as being "coupled" or "connected" to another component, it should be understood that the components may be directly coupled or connected to each other or coupled or connected to each other through another component interposed therebetween. In contrast, when one component is referred to as being "directly coupled" or "directly connected" to another component, it should be understood that the components are directly coupled or connected to each other without another component interposed therebetween.

A "logic high level" and a "logic low level" are used to describe the logic levels of signals. A signal having a "logic high level" is distinguished from a signal having a "logic low level." For example, when a signal having a first voltage corresponds to a signal having a "logic high level," a signal having a second voltage may correspond to a signal having a "logic low level." According to an embodiment, a "logic high level" may be set to a voltage higher than a "logic low level." According to an embodiment, the logic levels of signals may be set to different logic levels or opposite logic levels. For example, a signal having a logic high level may be set to have a logic low level in some embodiments, and a signal having a logic low level may be set to have a logic high level in some embodiments.

Hereafter, the present disclosure will be described in more detail through embodiments. The embodiments are only used to exemplify the present disclosure, and the scope of the present disclosure is not limited by the embodiments.

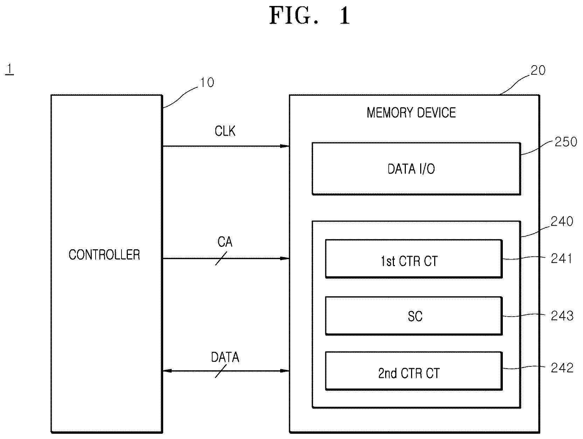

As illustrated in FIG. 1, a semiconductor system 1 according to an embodiment of the present disclosure may include a controller 10 and a memory device 20.

The controller 10 may transmit a clock CLK to the memory device 20. The controller 10 may transmit a command address CA to the memory device 20. The controller 10 may transmit data DATA to the memory device 20. The controller 10 may receive data DATA from the memory device 20. The clock CLK may be set as a signal that periodically toggles in order to synchronize operations of the controller 10 and the memory device 20. The command address CA may include multiple bits and may be set as a signal including a command that controls an operation of the memory device 20 and an address that selects multiple memory cells included in the memory circuit 330. The data DATA may be set as a signal that is to be stored in the multiple memory cells included in the memory circuit 240.

The memory device 20 may include a memory circuit 240 and a data input and output circuit (DATA I/O) 250.

The memory circuit 240 may include a first control circuit (1^{st} CTR CT) 241, a second control circuit (2^{nd} CTR CT) 242, and a data storage circuit (SC) 243.

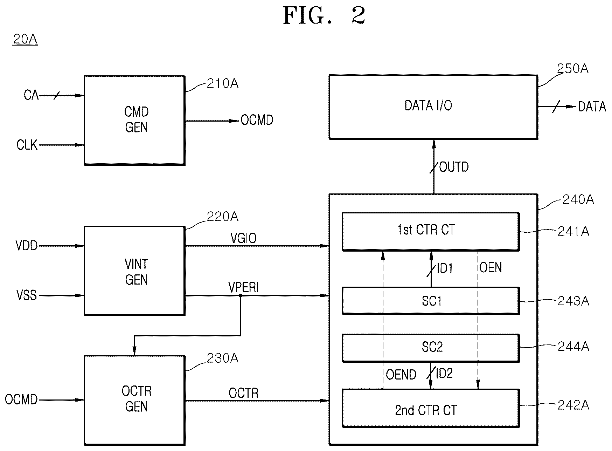

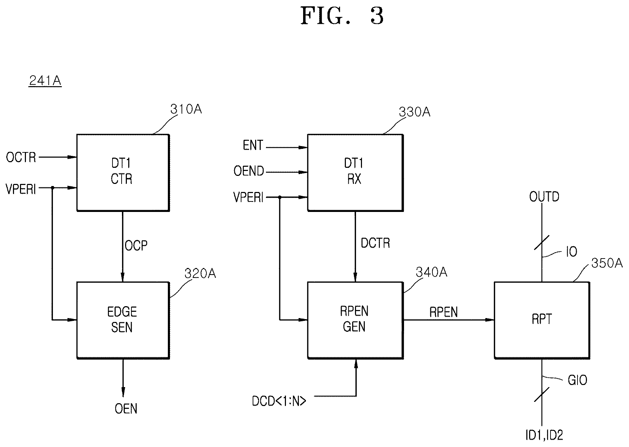

The first control circuit 241 may be disposed to be adjacent to the data input and output circuit 250. The first control circuit 241 may generate an output enable signal OEN as shown in FIG. 2, which is driven to a first internal voltage VPERI as shown in FIG. 2, by an output control pulse OCP as shown in FIG. 3, which is generated after the start of a data output operation, based on the command address CA. The first control circuit 241 may output the output enable signal OEN as shown in FIG. 2 to the second control circuit 242. The first control circuit 241 may receive a delay output enable signal OEND as shown in FIG. 2, which is driven to a second internal voltage VGIO as shown in FIG. 2, from the second control circuit 242. The first control circuit 241 may activate a repeater (RPT) 350A as shown in FIG. 3, by receiving the delay output enable signal OEND as shown in FIG. 2. The first control circuit 241 may generate output data OUTD as shown in FIG. 2, from internal data ID1 and ID2 as shown in FIG. 3, which are loaded onto a global line GIO as shown in FIG. 3, through the repeater 350A as shown in FIG. 3, and may output the output data to the data input and output circuit 250. The first control circuit 241 may adjust a timing at which the repeater 350A a shown in FIG. 3 is activated by compensating for an aggregate distance of a distance that the output enable signal OEN as shown in FIG. 2 travels and a distance that the delay output enable signal OEND as shown in FIG. 2 travels, and a voltage difference between the first internal voltage VPERI as shown in FIG. 2 and the second internal voltage VGIO as shown in FIG. 2.

The aggregate distance may be set as the sum of a distance that the output enable signal OEN as shown in FIG. 2 travels when output from the first control circuit 241 to the data storage circuit 243 and the second control circuit 242 and a distance that the delay output enable signal as shown in FIG. 2 travels when output from the second control circuit 242 to the data storage circuit 243 and the first control circuit 241.

The second control circuit 242 may be disposed to be adjacent to the data storage circuit 243. The second control circuit 242 may generate the delay output enable signal OEND as shown in FIG. 2 based on the output enable signal OEN as shown in FIG. 2, after the start of a data output operation based on the command address CA. The second control circuit 242 may receive the output enable signal OEN as shown in FIG. 2, which is driven to the first internal voltage VPERI as shown in FIG. 2, from the first control circuit 241 after the start of a data output operation. The second control circuit 242 may generate the delay output enable signal OEND as shown in FIG. 2, which is driven to the second internal voltage VGIO as shown in FIG. 2, based on the output enable signal OEN as shown in FIG. 2. The second control circuit 242 may output the delay output enable signal OEND as shown in FIG. 2 to the first control circuit 241. The second control circuit 242 may be disposed to be spaced apart from the data input and output circuit 250 with the first control circuit 241 and the data storage circuit 243 interspersed therebetween.

The data storage circuit 243 may be disposed to be adjacent to the first control circuit 241. The data storage circuit 243 may output the internal data ID1 and ID2 as shown in FIG. 3, which are stored in the data storage circuit 243, through the global line GIO as shown in FIG. 3, after the start of a data output operation based on the command address CA. The data storage circuit 243 may be implemented to perform a data output operation; however, the data storage circuit 243 may also be implemented with a common data storage circuit that stores the internal data ID1 and ID2 as shown in FIG. 3 in a plurality of memory cells after the start of a data storage operation.

The data input and output circuit 250 may receive the output data OUTD as shown in FIG. 2, from the first control circuit 241 after the start of a data output operation. The data input and output circuit 250 may generate the data DATA from the output data OUTD as shown in FIG. 2, after the start of a data output operation. The data input and output circuit 250 may output the data DATA to the controller 10.

The memory device 20 may perform a data output operation based on the command address CA that is input in synchronization with the clock CLK. The memory device 20 may adjust a timing at which the repeater 350A as shown in FIG. 3 is activated by compensating for an aggregate distance of a distance that the output enable signal OEN as shown in FIG. 2, for activating the repeater 350A as shown in FIG. 3, travels and a distance that the delay output enable signal OEND as shown in FIG. 2 travels, after the start of a data output operation and compensating for a voltage difference between the first internal voltage VPERI as shown in FIG. 2 and the second internal voltage VGIO as shown in FIG. 2. The memory device 20 may generate the output data OUTD as shown in FIG. 2 from the internal data ID1 and ID2 as shown in FIG. 3, which are loaded onto the global line GIO as shown in FIG. 3, when the repeater 350A as shown in FIG. 3 is activated after the start of a data output operation. The memory device 20 may generate the data DATA from the output data OUTD as shown in FIG. 2 after the start of a data output operation. The memory device 20 may output the data DATA to the controller 10.

FIG. 2 is a block diagram illustrating an example of the memory device 20 included in the semiconductor system 1. A memory device 20A may include a command generation circuit (CMD GEN) 210A, an internal voltage generation circuit (VINT GEN) 220A, an output control signal generation circuit (OCTR GEN) 230A, a memory circuit 240A, and a data input and output circuit (DATA I/O) 250A.

The command generation circuit 210A may generate an output command OCMD that is enabled when the command address CA that is input in synchronization with the clock CLK has a logic level combination for performing a data output operation. The command generation circuit 210A may be implemented to generate the output command OCMD; however, the command generation circuit 210A may be implemented to generate a command for controlling various operations, such as an active operation, data storage operation, and precharge operation of the memory device 20.

The internal voltage generation circuit 220A may generate the first internal voltage VPERI and the second internal voltage VGIO by being supplied with a power supply voltage VDD and a ground voltage VSS that are supplied from an external source. The internal voltage generation circuit 220A may be implemented with a common voltage generation circuit and may generate the first internal voltage VPERI and the second internal voltage VGIO by lowering the voltage level of the power supply voltage VDD that is supplied from the external source. The first internal voltage VPERI may be set as a voltage having a higher voltage level than the second internal voltage VGIO.

The output control signal generation circuit 230A may be supplied with the first internal voltage VPERI. The output control signal generation circuit 230A may generate an output control signal OCTR that is enabled when the output command OCMD is input. The output control signal generation circuit 230A may generate the output control signal OCTR that is driven to the voltage level of the first internal voltage VPERI when the output command OCMD is input.

The memory circuit 240A may include a first control circuit (1^{st} CTR CT) 241A, a second control circuit (2^{nd} CTR CT) 242A, a first data storage circuit (SC1) 243A, and a second data storage circuit (SC2) 244A.

The first control circuit 241A may be disposed to be adjacent to the data input and output circuit 250A. The first control circuit 241A may be supplied with the first internal voltage VPERI and the second internal voltage VGIO. The first control circuit 241A may generate the output enable signal OEN that is driven to the first internal voltage VPERI, based on an output control pulse OCP as shown in FIG. 3, which is generated when the output control signal OCTR is enabled, after the start of a data output operation. The first control circuit 241A may output the output enable signal OEN to the second control circuit 242A. The first control circuit 241A may receive the delay output enable signal OEND, which is driven to the second internal voltage VGIO, from the second control circuit 242A. The first control circuit 241A may activate the repeater 350A as shown in FIG. 3 by receiving the delay output enable signal OEND. The first control circuit 241A may generate the output data OUTD from the internal data ID1 and ID2 that are loaded onto the global line GIO as shown in FIG. 3, through the repeater 350A as shown in FIG. 3 and may output the output data to the data input and output circuit 250A. The first control circuit 241A may adjust a timing at which the repeater 350A as shown in FIG. 3 is activated by compensating for an aggregate distance of a distance that the output enable signal OEN travels and a distance that the delay output enable signal OEND travels and compensating for a voltage difference between the first internal voltage VPERI and the second internal voltage VGIO.

The aggregate distance may be set as the sum of a distance that the output enable signal OEN travels when output from the first control circuit 241A to the first data storage circuit 243A, the second data storage circuit 244A, and the second control circuit 242A and a distance that the delay output enable signal OEND travels when output from the second control circuit 242A to the second data storage circuit 244A, the first data storage circuit 243A, and the first control circuit 241A.

The second control circuit 242A may be disposed to be adjacent to the second data storage circuit 244A. The second control circuit 242A may be supplied with the first internal voltage VPERI and the second internal voltage VGIO. The second control circuit 242A may generate the delay output enable signal OEND based on the output enable signal OEN after the start of a data output operation. The second control circuit 242A may generate the delay output enable signal OEND that is driven to the second internal voltage VGIO based on the output enable signal OEN. The second control circuit 242A may output the delay output enable signal OEND to the first control circuit 241A. The second control circuit 242A may be disposed to be spaced apart from the data input and output circuit 250A with the the first control circuit 241A, the first data storage circuit 243A, and the second data storage circuit 244A interspersed therebetween. The second control circuit 242A may output the second internal data ID2 that are output by the second data storage circuit 244A to the global line GIO as shown in FIG. 3, when the output control signal OCTR is enabled.

The first data storage circuit 243A may be disposed to be adjacent to the first control circuit 241A. The first data storage circuit 243A may output the first internal data ID1 that are stored in the first data storage circuit 243A through the global line GIO as shown in FIG. 3, after the start of a data output operation. The first data storage circuit 243A may be implemented to perform a data output operation; however, the first data storage circuit 243A may also be implemented with a common data storage circuit that stores the first internal data ID1 in a plurality of memory cells after the start of a data storage operation.

The second data storage circuit 244A may be disposed to be adjacent to the first data storage circuit 243A. The second data storage circuit 244A may output the second internal data ID2 that are stored in the second data storage circuit 244A through the global line GIO as shown in FIG. 3, after the start of a data output operation. The second data storage circuit 244A may be implemented to perform a data output operation; however, the second data storage circuit 244A may also be implemented with a common data storage circuit that stores the second internal data ID2 in a plurality of memory cells after the start of a data storage operation.

The data input and output circuit 250A may receive the output data OUTD from the first control circuit 241A after the start of a data output operation. The data input and output circuit 250A may generate the data DATA from the output data OUTD after the start of a data output operation. The data input and output circuit 250A may output the data DATA to the controller 10.

The first internal data ID1, the second internal data ID2, the output data OUTD, and the data DATA according to an embodiment of the present disclosure may each be generated to have the voltage level of the ground voltage VSS or the second internal voltage VGIO. A case in which each of the first internal data ID1, the second internal data ID2, the output data OUTD, and the data DATA is generated to have the voltage level of the ground voltage VSS may correspond to a case in which each of the first internal data ID1, the second internal data ID2, the output data OUTD, and the data DATA is in a logic low level. A case in which each of the first internal data ID1, the second internal data ID2, the output data OUTD, and the data DATA is generated to have the voltage level of the second internal voltage VGIO may correspond to a case in which each of the first internal data ID1, the second internal data ID2, the output data OUTD, and the data DATA is in a logic high level.

The memory device 20A may perform a data output operation based on the command address CA that is input in synchronization with the clock CLK. The memory device 20A may adjust a timing at which the repeater 350A as shown in FIG. 3 is activated by compensating for an aggregate distance of a distance that the output enable signal OEN for activating the repeater 350A as shown in FIG. 3 travels and a distance that the delay output enable signal OEND travels after the start of a data output operation and a voltage difference between the first internal voltage VPERI and the second internal voltage VGIO. The memory device 20A may generate the output data OUTD from the internal data ID1 and ID2 loaded onto the global line GIO as shown in FIG. 3, when the repeater 350A as shown in FIG. 3, is activated after the start of a data output operation. The memory device 20A may generate the data DATA from the output data OUTD after the start of a data output operation. The memory device 20A may output the data DATA to the controller 10.

FIG. 3 is a block diagram illustrating an example of the first control circuit 241A included in the memory device 20A. The first control circuit 241A may include a first data control circuit (DT1 CTR) 310A, an edge sensing circuit (EDGE SEN) 320A, a first data receiver (DT1 RX) 330A, a repeater enable signal generation circuit (RPEN GEN) 340A, and the repeater (RPT) 350A.

The first data control circuit 310A may be supplied with the first internal voltage VPERI. The first data control circuit 310A may generate the output control pulse OCP including a pulse that is generated based on the output control signal OCTR. The first data control circuit 310A may generate the output control pulse OCP including a pulse that is generated when the output control signal OCTR is enabled. The first data control circuit 310A may generate the output control pulse OCP including a pulse that is generated to have the voltage level of the first internal voltage VPERI when the output control signal OCTR is enabled.

The edge sensing circuit 320A may be supplied with the first internal voltage VPERI. The edge sensing circuit 320A may generate the output enable signal OEN by sensing an edge at which the level of the output control pulse OCP transitions. The edge sensing circuit 320A may generate the output enable signal OEN by sensing a rising edge at which the level of the output control pulse OCP transitions from a logic low level to a logic high level. The edge sensing circuit 320A may generate the output enable signal OEN that is generated to have the voltage level of the first internal voltage VPERI when the level of the output control pulse OCP transitions from a logic low level to a logic high level.

The first data receiver 330A may be supplied with the first internal voltage VPERI. The first data receiver 330A may generate a data control signal DCTR based on the delay output enable signal OEND that is driven to the second internal voltage VGIO during an interval in which an enable interval signal ENT is enabled. The first data receiver 330A may generate the data control signal DCTR that is generated to have the voltage level of the first internal voltage VPERI when the delay output enable signal OEND is input to have the second internal voltage VGIO during an interval in which the enable interval signal ENT is enabled. The enable interval signal ENT may be set as a signal that is enabled for a predetermined interval after the start of a data output operation.

The repeater enable signal generation circuit 340A may be supplied with the first internal voltage VPERI. The repeater enable signal generation circuit 340A may generate a repeater enable signal RPEN by delaying the data control signal DCTR by a delay amount that is adjusted by a delay code DCD<1:N>. The repeater enable signal generation circuit 340A may generate the repeater enable signal RPEN that is generated to have the voltage level of the first internal voltage VPERI by delaying the data control signal DCTR by a delay amount that is adjusted by the delay code DCD<1:N>. The delay code DCD<1:N> may be generated to have various logic level combinations for adjusting the aggregate distance. The delay code DCD<1:N> may be set as a signal that is input from the controller 10 or a circuit, such as a mode register set (MRS) included in the memory device 20A.

The repeater 350A may be activated when the repeater enable signal RPEN is enabled. The repeater 350A may generate the output data OUTD from the first internal data ID1 or the second internal data ID2 loaded onto the global line GIO when the repeater enable signal RPEN is enabled. The repeater 350A may generate the output data OUTD by driving an input and output line IO based on the logic level of the first internal data ID1 or the second internal data ID2 when the repeater enable signal RPEN is enabled. The repeater 350A may output the output data OUTD to the data input and output circuit 250A through the input and output line IO. The first internal data ID1, the second internal data ID2, and the output data OUTD may each be set as common data including a plurality of bits.

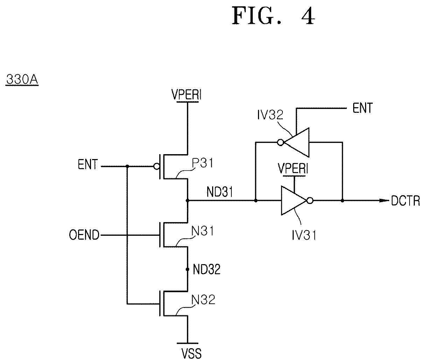

FIG. 4 is a circuit diagram illustrating an example of the first data receiver 330A included in the first control circuit 241A.

The first data receiver 330A may be implemented with a PMOS transistor P31 that is disposed between the first internal voltage VPERI and a node ND31 and that drives the node ND31 to the first internal voltage VPERI when the enable interval signal ENT is disabled to a logic low level. The first data receiver 330A may be implemented with an NMOS transistor N31 that is disposed between the node ND31 and a node ND32 and that discharges the charges of the node ND31 when the delay output enable signal OEND is input to have the second internal voltage VGIO. The first data receiver 330A may be implemented with an NMOS transistor N32 that is disposed between the node ND32 and the ground voltage VSS and discharges the charges of the node ND32 to the ground voltage VSS when the enable interval signal ENT is enabled to a logic high level. The first data receiver 330A may be implemented with inverters IV31 and IV32 that are supplied with the first internal voltage VPERI, generating the data control signal DCTR that is generated to have the voltage level of the first internal voltage VPERI when the node ND31 is driven to the ground voltage VSS and latching the voltage level of the node ND31 when the enable interval signal ENT is enabled to a logic high level.

When the enable interval signal ENT is enabled to a logic high level and the delay output enable signal OEND is input to have the second internal voltage VGIO, the first data receiver 330A may generate the data control signal DCTR that is generated to have the voltage level of the first internal voltage VPERI. The first data receiver 330A may generate the data control signal DCTR that is disabled to a logic low level when the enable interval signal ENT is disabled to a logic low level.

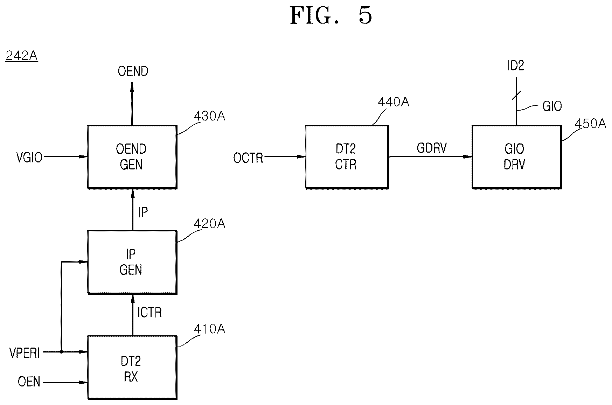

FIG. 5 is a block diagram illustrating an example of the second control circuit 242A included in the memory device 20A. The second control circuit 242A may include a second data receiver (DT2 RX) 410A, an internal pulse generation circuit (IP GEN) 420A, a delay output enable signal generation circuit (OEND GEN) 430A, a second data control circuit (DT2 CTR) 440A, and a global input and output line driver (GIO DRV) 450A.

The second data receiver 410A may be supplied with the first internal voltage VPERI. The second data receiver 410A may generate an internal control signal ICTR based on the output enable signal OEN. The second data receiver 410A may generate the internal control signal ICTR that is generated to have the voltage level of the first internal voltage VPERI when the output enable signal OEN is input to have the first internal voltage VPERI. The second data receiver 410A may generate the internal control signal ICTR having the voltage level of the first internal voltage VPERI by delaying the output enable signal OEN having the voltage level of the first internal voltage VPERI.

The internal pulse generation circuit 420A may be supplied with the first internal voltage VPERI. The internal pulse generation circuit 420A may generate an internal pulse IP based on the internal control signal ICTR. The internal pulse generation circuit 420A may generate the internal pulse IP that is generated to have the voltage level of the first internal voltage VPERI when the internal control signal ICTR is input to have the first internal voltage VPERI. The internal pulse generation circuit 420A may generate the internal pulse IP having the voltage level of the first internal voltage VPERI by delaying the internal control signal ICTR having the voltage level of the first internal voltage VPERI.

The delay output enable signal generation circuit 430A may be supplied with the second internal voltage VGIO. The delay output enable signal generation circuit 430A may generate the delay output enable signal OEND based on the internal pulse IP. The delay output enable signal generation circuit 430A may generate the delay output enable signal OEND that is generated to have the voltage level of the second internal voltage VGIO when the internal pulse IP is input to have the first internal voltage VPERI. The delay output enable signal generation circuit 430A may convert the voltage level of the internal pulse IP having the voltage level of the first internal voltage VPERI into the voltage level of the second internal voltage VGIO and may generate the delay output enable signal OEND having the voltage level of the second internal voltage VGIO by delaying the internal pulse IP.

The second data control circuit 440A may generate a driving signal GDRV including a pulse that is generated based on the output control signal OCTR. The second data control circuit 440A may generate the driving signal GDRV including a pulse that is generated when the output control signal OCTR is enabled. The second data control circuit 440A may generate the driving signal GDRV including a pulse that is generated when the output control signal OCTR is generated to have the voltage level of the first internal voltage VPERI.

The global input and output line driver 450A may be turned on when a pulse of the driving signal GDRV is input. The global input and output line driver 450A may output the second internal data ID2 that are output by the second data storage circuit 244A to the global input and output line GIO when a pulse of the driving signal GDRV is input.

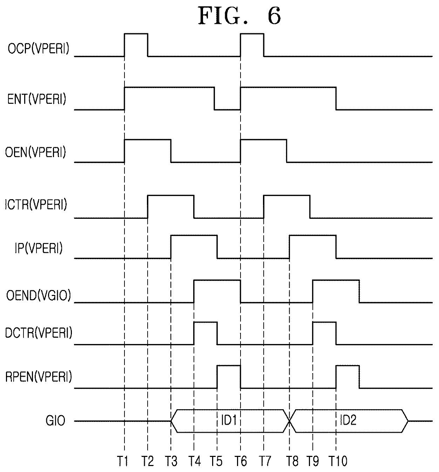

FIG. 6 is a timing diagram for describing an operation of the memory device 20A according to an embodiment of the present disclosure. A data output operation of the memory device 20A is described with reference to FIG. 6. In this case, a data output operation for the second data storage circuit 244A, after performing a data output operation for the first data storage circuit 243A, is described as follows.

At time T1, the first data control circuit 310A may generate the output control pulse OCP including a pulse that is generated to have the voltage level of the first internal voltage VPERI when the output control signal OCTR is enabled.

The edge sensing circuit 320A may generate the output enable signal OEN that is generated to have the voltage level of the first internal voltage VPERI when the level of the output control pulse OCP transitions from a logic low level to a logic high level.

At time T2, the second data receiver 410A may generate the internal control signal ICTR having the voltage level of the first internal voltage VPERI by delaying the output enable signal OEN, which has the voltage level of the first internal voltage VPERI and has been generated at time T1.

At time T3, the internal pulse generation circuit 420A may generate the internal pulse IP having the voltage level of the first internal voltage VPERI by delaying the internal control signal ICTR, which has the voltage level of the first internal voltage VPERI and has been generated at time T2.

The first data storage circuit 243A may output the first internal data ID1 that are stored in the first data storage circuit 243A through the global line GIO.

At time T4, the delay output enable signal generation circuit 430A may convert the voltage level of the internal pulse IP, which has the voltage level of the first internal voltage VPERI and has been generated at time T3, into the voltage level of the second internal voltage VGIO and may generate the delay output enable signal OEND having the voltage level of the second internal voltage VGIO by delaying the internal pulse IP.

When the delay output enable signal OEND is input to have the second internal voltage VGIO during an interval in which the enable interval signal ENT is enabled to a logic high level, the first data receiver 330A may generate the data control signal DCTR that is generated to have the voltage level of the first internal voltage VPERI.

At time T5, the repeater enable signal generation circuit 340A may generate the repeater enable signal RPEN that is generated to have the voltage level of the first internal voltage VPERI by delaying the data control signal DCTR, which has been generated at time T4, by a delay amount that is adjusted by the delay code DCD<1:N>.

The repeater 350A may generate the output data OUTD by driving the input and output line IO based on the logic level of the first internal data ID1 when the repeater enable signal RPEN is enabled. The repeater 350A may output the output data OUTD to the data input and output circuit 250A through the input and output line IO.

At time T6, the first data control circuit 310A may generate the output control pulse OCP including a pulse that is generated to have the voltage level of the first internal voltage VPERI when the output control signal OCTR is enabled.

The edge sensing circuit 320A may generate the output enable signal OEN that is generated to have the voltage level of the first internal voltage VPERI when the level of the output control pulse OCP transitions from a logic low level to a logic high level.

At time T7, the second data receiver 410A may generate the internal control signal ICTR having the voltage level of the first internal voltage VPERI by delaying the output enable signal OEN, which has the voltage level of the first internal voltage VPERI and has been generated at time T6.

At time T8, the internal pulse generation circuit 420A may generate the internal pulse IP having the voltage level of the first internal voltage VPERI by delaying the internal control signal ICTR, which has the voltage level of the first internal voltage VPERI and has been generated at time T7.

The second data storage circuit 244A may output the second internal data ID2 that are stored in the second data storage circuit 244A through the global line GIO.

At time T9, the delay output enable signal generation circuit 430A may convert the voltage level of the internal pulse IP, which has the voltage level of the first internal voltage VPERI and has been generated at time T8, into the voltage level of the second internal voltage VGIO and may generate the delay output enable signal OEND having the voltage level of the second internal voltage VGIO by delaying the internal pulse IP.

When the delay output enable signal OEND is input to have the second internal voltage VGIO during an interval in which the enable interval signal ENT is enabled to a logic high level, the first data receiver 330A may generate the data control signal DCTR that is generated to have the voltage level of the first internal voltage VPERI.

At time T10, the repeater enable signal generation circuit 340A may generate the repeater enable signal RPEN that is generated to have the voltage level of the first internal voltage VPERI by delaying the data control signal DCTR, which has been generated at time T9, by a delay amount that is adjusted by the delay code DCD<1:N>.

The repeater 350A may generate the output data OUTD by driving the input and output line IO based on the logic level of the second internal data ID2 when the repeater enable signal RPEN is enabled. The repeater 350A may output the output data OUTD to the data input and output circuit 250A through the input and output line IO.

The memory device 20A can secure a margin between data and an enable signal because the data are output by compensating for a delay due to an aggregate distance traveled by the enable signals that activate the repeater 350A, and a voltage difference between the heterogeneous power supplies VPERI and VGIO. The memory device 20A can prevent an error from occurring in data because the data are output by compensating for a delay due to an aggregate distance traveled by the enable signals that activate the repeater 350A and the voltage difference between the heterogeneous power supplies VPERI and VGIO.

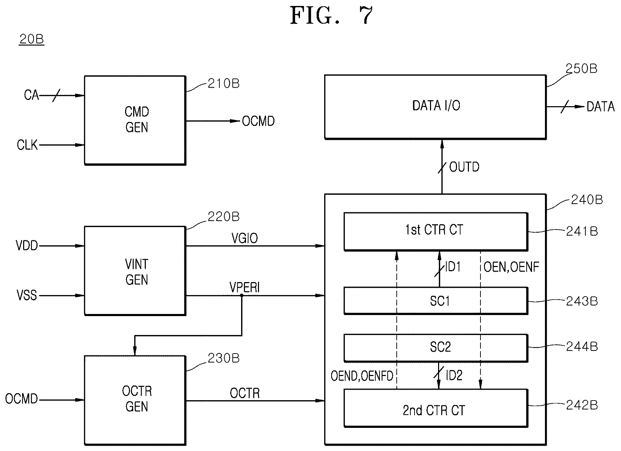

FIG. 7 is a block diagram illustrating an example of the memory device 20 included in the semiconductor system 1. A memory device 20B may include a command generation circuit (GMD GEN) 210B, an internal voltage generation circuit (VINT GEN) 220B, an output control signal generation circuit (OCTR GEN) 230B, a memory circuit 240B, and a data input and output circuit (DATA I/O) 250B.

The command generation circuit 210B may generate an output command OCMD that is enabled when the command address CA that is input in synchronization with the clock CLK has a logic level combination for performing a data output operation. The command generation circuit 210B may be implemented to generate the output command OCMD; however, the command generation circuit 210B may be implemented to generate a command for controlling various operations, such as an active operation, data storage operation, and precharge operation of the memory device 20B.

The internal voltage generation circuit 220B may generate a first internal voltage VPERI and a second internal voltage VGIO by being supplied with a power supply voltage VDD and a ground voltage VSS that are supplied from the external source. The internal voltage generation circuit 220B may be implemented with a common voltage generation circuit and may generate the first internal voltage VPERI and the second internal voltage VGIO by lowering the voltage level of the power supply voltage VDD that is supplied from the external source. The first internal voltage VPERI may be set as a voltage having a higher voltage level than the second internal voltage VGIO.

The output control signal generation circuit 230B may be supplied with the first internal voltage VPERI. The output control signal generation circuit 230B may generate an output control signal OCTR that is enabled when the output command OCMD is input. The output control signal generation circuit 230B may generate the output control signal OCTR that is driven to the voltage level of the first internal voltage VPERI when the output command OCMD is input.

The memory circuit 240B may include a first control circuit (1^{St} CTR CT) 241B, a second control circuit (2^{nd} CTR CT) 242B, a first data storage circuit (SC1) 243B, and a second data storage circuit (SC2) 244B.

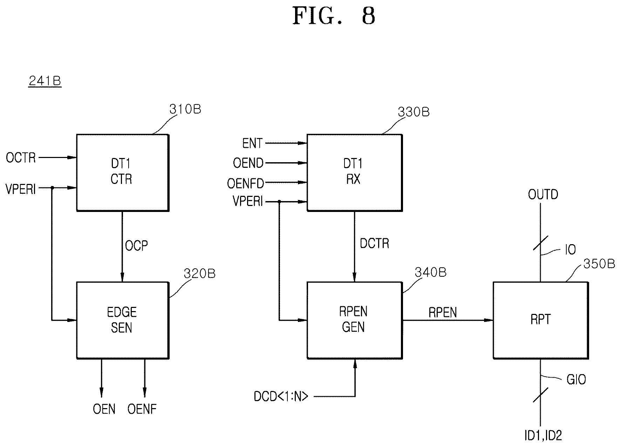

The first control circuit 241B may be disposed to be adjacent to the data input and output circuit 250B. The first control circuit 241B may be supplied with the first internal voltage VPERI and the second internal voltage VGIO. The first control circuit 241B may generate a rising output enable signal OEN and a falling output enable signal OENF that are driven to the first internal voltage VPERI by sensing an edge at which the level of an output control pulse OCP as shown in FIG. 8, which is generated when the output control signal OCTR is enabled, transitions after the start of a data output operation. The first control circuit 241B may generate the rising output enable signal OEN that is driven to the first internal voltage VPERI by sensing a rising edge of the output control pulse OCP as shown in FIG. 8, which is generated when the output control signal OCTR is enabled, after the start of a data output operation. The first control circuit 241B may generate the falling output enable signal OENF that is driven to the first internal voltage VPERI by sensing a falling edge of the output control pulse OCP as shown in FIG. 8, which is generated when the output control signal OCTR is enabled, after the start of a data output operation. The first control circuit 241B may output the rising output enable signal OEN and the falling output enable signal OENF to the second control circuit 242B. The first control circuit 241B may receive a rising delay output enable signal OEND and a falling delay output enable signal OENFD that are driven to the second internal voltage VGIO from the second control circuit 242B. The first control circuit 241B may activate a repeater (RPT) 350B as shown in FIG. 8, by receiving the rising delay output enable signal OEND and the falling delay output enable signal OENFD. The first control circuit 241B may generate output data OUTD from internal data ID1 and ID2 loaded onto a global line GIO as shown in FIG. 8, through the repeater 350B as shown in FIG. 8, and may output the output data to the data input and output circuit 250B. The first control circuit 241B may adjust a timing at which the repeater 350B as shown in FIG. 8, is activated by compensating for an aggregate distance of a distance that the rising output enable signal OEN and the falling output enable signal OENF travel and a distance that the rising delay output enable signal OEND and the falling delay output enable signal OENFD travel and a voltage difference between the first internal voltage VPERI and the second internal voltage VGIO.

The aggregate distance may be set as the sum of a distance that the rising output enable signal OEN and the falling output enable signal OENF travel when output from the first control circuit 241B to the first data storage circuit 243B, the second data storage circuit, 244B, and the second control circuit 242B and a distance that the rising delay output enable signal OEND and the falling delay output enable signal OENFD travel when output from the second control circuit 242B to the second data storage circuit 244B, the first data storage circuit 243B, and the first control circuit 241B.

The second control circuit 242B may be disposed to be adjacent to the second data storage circuit 244B. The second control circuit 242B may be supplied with the first internal voltage VPERI and the second internal voltage VGIO. The second control circuit 242B may generate the rising delay output enable signal OEND and the falling delay output enable signal OENFD based on the rising output enable signal OEN and the falling output enable signal OENF after the start of a data output operation. The second control circuit 242B may generate the rising delay output enable signal OEND and the falling delay output enable signal OENFD that are driven to the second internal voltage VGIO based on the rising output enable signal OEN and the falling output enable signal OENF. The second control circuit 242B may output the rising delay output enable signal OEND and the falling delay output enable signal OENFD to the first control circuit 241B. The second control circuit 242B may be disposed to be spaced apart from the data input and output circuit 250B with the first control circuit 241B, the first data storage circuit 243B, and the second data storage circuit 244B interspersed therebetween. The second control circuit 242B may output the second internal data ID2 that are output by the second data storage circuit 244B to the global line GIO as shown in FIG. 8, when the output control signal OCTR is enabled.

The first data storage circuit 243B may be disposed to be adjacent to the first control circuit 241B. The first data storage circuit 243B may output the first internal data ID1 that are stored in the first data storage circuit 243B through the global line GIO as shown in FIG. 8, after the start of a data output operation. The first data storage circuit 243B may be implemented to perform a data output operation; however, the first data storage circuit 243B may also be implemented with a common data storage circuit that stores the first internal data ID1 in a plurality of memory cells after the start of a data storage operation.

The second data storage circuit 244B may be disposed to be adjacent to the first data storage circuit 243B. The second data storage circuit 244B may output the second internal data ID2 that are stored in the second data storage circuit 244B through the global line GIO as shown in FIG. 8, after the start of a data output operation. The second data storage circuit 244B may be implemented to perform a data output operation; however, the second data storage circuit 244B may also be implemented with a common data storage circuit that stores the second internal data ID2 in a plurality of memory cells after the start of a data storage operation.

The data input and output circuit 250B may receive the output data OUTD from the first control circuit 241B after the start of a data output operation. The data input and output circuit 250B may generate the data DATA from the output data OUTD after the start of a data output operation. The data input and output circuit 250B may output the data DATA to the controller 10.

The first internal data ID1, the second internal data ID2, the output data OUTD, and the data DATA according to an embodiment of the present disclosure may each be generated to have the voltage level of the ground voltage VSS or the second internal voltage VGIO. A case in which the first internal data ID1, the second internal data ID2, the output data OUTD, and the data DATA are generated to have the voltage level of the ground voltage VSS may correspond to that a case in which each of the first internal data ID1, the second internal data ID2, the output data OUTD, and the data DATA is in a logic low level. A case in which the first internal data ID1, the second internal data ID2, the output data OUTD, and the data DATA are each generated to have the voltage level of the second internal voltage VGIO may correspond to that a case in which each of the first internal data ID1, the second internal data ID2, the output data OUTD, and the data DATA is in a logic high level.

The memory device 20B may perform a data output operation based on the command address CA that is input in synchronization with the clock CLK. The memory device 20B may generate the rising output enable signal OEN and the falling output enable signal OENF that are driven to the first internal voltage VPERI by sensing an edge at which the level of the output control pulse OCP as shown in FIG. 8 transitions after the start of a data output operation and may adjust a timing at which the repeater 350B as shown in FIG. 8, is activated by compensating for an aggregate distance of a distance that the rising output enable signal OEN and the falling output enable signal OENF travel and a distance that the rising delay output enable signal OEND and the falling delay output enable signal OENFD travel and a voltage difference between the first internal voltage VPERI and the second internal voltage VGIO. The memory device 20B may generate the output data OUTD from the internal data ID1 and ID2 loaded onto the global line GIO as shown in FIG. 8, when the repeater 350B as shown in FIG. 8, is activated after the start of a data output operation. The memory device 20B may generate the data DATA from the output data OUTD after the start of a data output operation. The memory device 20B may output the data DATA to the controller 10.

FIG. 8 is a block diagram illustrating an example of the first control circuit 241B included in the memory device 20B. The first control circuit 241B may include a first data control circuit (DT1 CTR) 310B, an edge sensing circuit (EDGE SEN) 320B, a first data receiver (DT1 RX) 330B, a repeater enable signal generation circuit (RPEN GEN) 340B, and the repeater (RPT) 350B.

The first data control circuit 310B may be supplied with the first internal voltage VPERI. The first data control circuit 310B may generate the output control pulse OCP including a pulse that is generated based on the output control signal OCTR. The first data control circuit 310B may generate the output control pulse OCP including a pulse that is generated when the output control signal OCTR is enabled. The first data control circuit 310B may generate the output control pulse OCP including a pulse that is generated to have the voltage level of the first internal voltage VPERI when the output control signal OCTR is enabled.

The edge sensing circuit 320B may be supplied with the first internal voltage VPERI. The edge sensing circuit 320B may generate the rising output enable signal OEN and the falling output enable signal OENF by sensing an edge at which the level of the output control pulse OCP transitions. The edge sensing circuit 320B may generate the rising output enable signal OEN by sensing a rising edge at which the level of the output control pulse OCP transitions from a logic low level to a logic high level. The edge sensing circuit 320B may generate the rising output enable signal OEN that is generated to have the voltage level of the first internal voltage VPERI when the level of the output control pulse OCP transitions from a logic low level to a logic high level. The edge sensing circuit 320B may generate the falling output enable signal OENF by sensing a falling edge at which the level of the output control pulse OCP transitions from a logic high level to a logic low level. The edge sensing circuit 320A may generate the falling output enable signal OENF that is generated to have the voltage level of the first internal voltage VPERI when the level of the output control pulse OCP transitions from a logic high level to a logic low level.

The first data receiver 330B may be supplied with the first internal voltage VPERI. The first data receiver 330B may generate a data control signal DCTR based on the rising delay output enable signal OEND and the falling delay output enable signal OENFD that are driven to the second internal voltage VGIO during an interval in which an enable interval signal ENT is enabled. The first data receiver 330B may generate the data control signal DCTR that is generated to have the voltage level of the first internal voltage VPERI when the rising delay output enable signal OEND is input to have the second internal voltage VGIO and the falling delay output enable signal OENFD is input to have the second internal voltage VGIO during an interval in which the enable interval signal ENT is enabled.

The repeater enable signal generation circuit 340B may be supplied with the first internal voltage VPERI. The repeater enable signal generation circuit 340B may generate a repeater enable signal RPEN by delaying the data control signal DCTR by a delay amount that is adjusted by a delay code DCD<1:N>. The repeater enable signal generation circuit 340B may generate the repeater enable signal RPEN that is generated to have the voltage level of the first internal voltage VPERI by delaying the data control signal DCTR by a delay amount that is adjusted by the delay code DCD<1:N>. The delay code DCD<1:N> may be generated to have various logic level combinations for adjusting the aggregate distance. The delay code DCD<1:N> may be set as a signal that is input from the controller 10 or a circuit, such as a mode register set (MRS) included in the memory device 20B.

The repeater 350B may be activated when the repeater enable signal RPEN is enabled. The repeater 350B may generate the output data OUTD from the first internal data ID1 or the second internal data ID2 loaded onto the global line GIO when the repeater enable signal RPEN is enabled. The repeater 350B may generate the output data OUTD by driving an input and output line IO based on the logic level of the first internal data ID1 or the second internal data ID2 when the repeater enable signal RPEN is enabled. The repeater 350B may output the output data OUTD to the data input and output circuit 250B through the input and output line IO. The first internal data ID1, the second internal data ID2, and the output data OUTD may be set as common data including a plurality of bits.

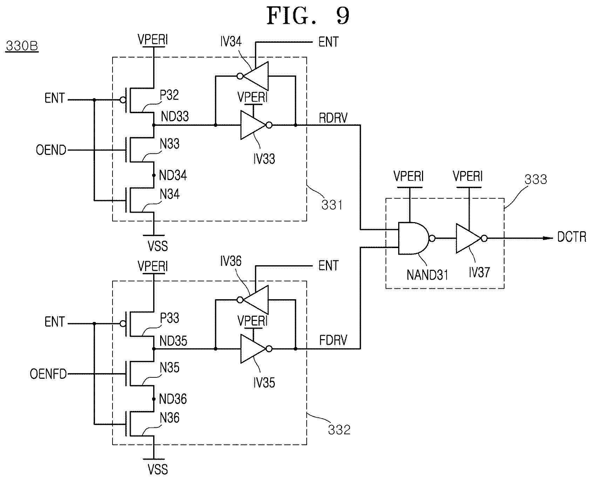

FIG. 9 is a circuit diagram illustrating an example of the first data receiver 330B included in the first control circuit 241B. The first data receiver 330B may include a first driving circuit 331, a second driving circuit 332, and a signal synthesis circuit 333.

The first driving circuit 331 may be implemented with a PMOS transistor P32 that is disposed between the first internal voltage VPERI and a node ND33 and that drives the node ND33 to the first internal voltage VPERI when the enable interval signal ENT is disabled to a logic low level. The first driving circuit 331 may be implemented with an NMOS transistor N33 that is disposed between the node ND33 and a node ND34 and that discharges the charges of the node ND33 when the rising delay output enable signal OEND is input to have the second internal voltage VGIO. The first driving circuit 331 may be implemented with an NMOS transistor N34 that is disposed between the node ND34 and the ground voltage VSS and that discharges the charges of the node ND34 to the ground voltage VSS when the enable interval signal ENT is enabled to a logic high level. The first driving circuit 331 may be implemented with inverters IV33 and IV34 that are supplied with the first internal voltage VPERI, generating a rising driving signal RDRV that is generated to have the voltage level of the first internal voltage VPERI when the node ND33 is driven to the ground voltage VSS and latching the voltage level of the node ND33 when the enable interval signal ENT is enabled to a logic high level.

The first driving circuit 331 may be supplied with the first internal voltage VPERI. The first driving circuit 331 may generate the rising driving signal RDRV that is disabled to a logic low level when the enable interval signal ENT is disabled to a logic low level. When the enable interval signal ENT is enabled to a logic high level and the rising delay output enable signal OEND that is driven to the second internal voltage VGIO is enabled, the first driving circuit 331 may generate the rising driving signal RDRV that is enabled to the first internal voltage VPERI by driving the node ND33.

The second driving circuit 332 may be implemented with a PMOS transistor P33 that is disposed between the first internal voltage VPERI and a node ND35 and that drives the node ND35 to the first internal voltage VPERI when the enable interval signal ENT is disabled to a logic low level. The second driving circuit 332 may be implemented with an NMOS transistor N35 that is disposed between the node ND35 and a node ND36 and that discharges the charges of the node ND35 when the falling delay output enable signal OENFD is input to have the second internal voltage VGIO. The second driving circuit 332 may be implemented with an NMOS transistor N36 that is disposed between the node ND36 and the ground voltage VSS and that discharges the charges of the node ND36 to the ground voltage VSS when the enable interval signal ENT is enabled to a logic high level. The second driving circuit 332 may be implemented with inverters IV35 and IV36 that are supplied with the first internal voltage VPERI, generating a falling driving signal FDRV that is generated to have the voltage level of the first internal voltage VPERI when the node ND35 is driven to the ground voltage VSS and latching the voltage level of the node ND35 when the enable interval signal ENT is enabled to a logic high level.

The second driving circuit 332 may be supplied with the first internal voltage VPERI. The second driving circuit 332 may generate the falling driving signal FDRV that is disabled to a logic low level when the enable interval signal ENT is disabled to a logic low level. When the enable interval signal ENT is enabled to a logic high level and the falling delay output enable signal OENFD that is driven to the second internal voltage VGIO is enabled, the second driving circuit 332 may generate the falling driving signal FDRV that is enabled to the first internal voltage VPERI by driving the node ND35.

The signal synthesis circuit 333 may be implemented with an NAND gate NAND31 and an inverter IV37.

The signal synthesis circuit 333 may be supplied with the first internal voltage VPERI. The signal synthesis circuit 333 may generate the data control signal DCTR by synthesizing the rising driving signal RDRV and the falling driving signal FDRV. The signal synthesis circuit 333 may generate the data control signal DCTR that is enabled to the first internal voltage VPERI, when the rising driving signal RDRV is enabled and the falling driving signal FDRV is enabled. When any one of the rising driving signal RDRV and the falling driving signal FDRV is disabled, the signal synthesis circuit 333 may generate the data control signal DCTR that is disabled to the ground voltage VSS.

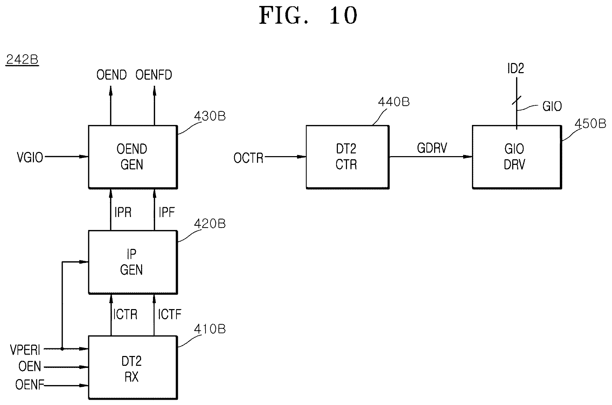

FIG. 10 is a block diagram illustrating an example of the second control circuit 242B included in the memory device 20B. The second control circuit 242B may include a second data receiver (DT2 RX) 410B, an internal pulse generation circuit (IP GEN) 420B, a delay output enable signal generation circuit (OEND GEN) 430B, a second data control circuit (DT2 CTR) 440B, and a global input and output line driver (GIO DRV) 450B.

The second data receiver 410B may be supplied with the first internal voltage VPERI. The second data receiver 410B may generate a rising internal control signal ICTR and a falling internal control signal ICTF based on the rising output enable signal OEN and the falling output enable signal OENF. The second data receiver 410B may generate the rising internal control signal ICTR that is generated to have the voltage level of the first internal voltage VPERI when the rising output enable signal OEN is input to have the first internal voltage VPERI. The second data receiver 410B may generate the rising internal control signal ICTR having the voltage level of the first internal voltage VPERI by delaying the rising output enable signal OEN having the voltage level of the first internal voltage VPERI. The second data receiver 410B may generate the falling internal control signal ICTF that is generated to have the voltage level of the first internal voltage VPERI when the falling output enable signal OENF is input to have the first internal voltage VPERI. The second data receiver 410B may generate the falling internal control signal ICTF having the voltage level of the first internal voltage VPERI by delaying the falling output enable signal OENF having the voltage level of the first internal voltage VPERI.

The internal pulse generation circuit 420B may be supplied with the first internal voltage VPERI. The internal pulse generation circuit 420B may generate a rising internal pulse IPR and a falling internal pulse IPF based on the rising internal control signal ICTR and the falling internal control signal ICTF. The internal pulse generation circuit 420B may generate the rising internal pulse IPR that is generated to have the voltage level of the first internal voltage VPERI when the rising internal control signal ICTR is input to have the first internal voltage VPERI. The internal pulse generation circuit 420B may generate the rising internal pulse IPR having the voltage level of the first internal voltage VPERI by delaying the rising internal control signal ICTR having the voltage level of the first internal voltage VPERI. The internal pulse generation circuit 420B may generate the falling internal pulse IPF that is generated to have the voltage level of the first internal voltage VPERI when the falling internal control signal ICTF is input to have the first internal voltage VPERI. The internal pulse generation circuit 420B may generate the falling internal pulse IPF having the voltage level of the first internal voltage VPERI by delaying the falling internal control signal ICTF having the voltage level of the first internal voltage VPERI.

The delay output enable signal generation circuit 430B may be supplied with the second internal voltage VGIO. The delay output enable signal generation circuit 430B may generate the rising delay output enable signal OEND and the falling delay output enable signal OENFD based on the rising internal pulse IPR and the falling internal pulse IPF. The delay output enable signal generation circuit 430B may generate the rising delay output enable signal OEND that is generated to have the voltage level of the second internal voltage VGIO when the rising internal pulse IPR is input to have the first internal voltage VPERI. The delay output enable signal generation circuit 430B may convert the voltage level of the rising internal pulse IPR having the voltage level of the first internal voltage VPERI into the voltage level of the second internal voltage VGIO and may generate the rising delay output enable signal OEND having the voltage level of the second internal voltage VGIO by delaying the rising internal pulse IPR. The delay output enable signal generation circuit 430B may generate the falling delay output enable signal OENFD that is generated to have the voltage level of the second internal voltage VGIO when the falling internal pulse IPF is input to have the first internal voltage VPERI. The delay output enable signal generation circuit 430B may convert the voltage level of the falling internal pulse IPF having the voltage level of the first internal voltage VPERI into the voltage level of the second internal voltage VGIO and may generate the falling delay output enable signal OENFD having the voltage level of the second internal voltage VGIO by delaying the falling internal pulse IPR.

The second data control circuit 440B may generate a driving signal GDRV including a pulse that is generated based on the output control signal OCTR. The second data control circuit 440B may generate the driving signal GDRV including a pulse that is generated when the output control signal OCTR is enabled. The second data control circuit 440B may generate the driving signal GDRV including a pulse that is generated when the output control signal OCTR is generated to have the voltage level of the first internal voltage VPERI.

The global input and output line driver 450B may be turned on when a pulse of the driving signal GDRV is input. The global input and output line driver 450B may output the second internal data ID2 that are output by the second data storage circuit 244B to the global input and output line GIO when a pulse of the driving signal GDRV is input.

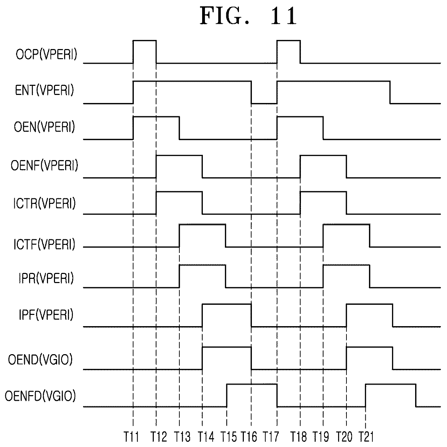

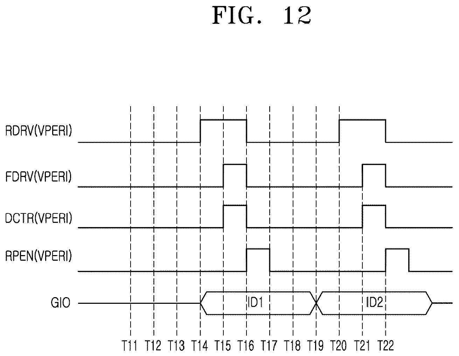

FIGS. 11 and 12 are timing diagrams for describing an operation of the memory device 20B according to an embodiment of the present disclosure.

Data output operations of the memory device 20B are described with reference to FIGS. 11 and 12. In this case, data output operations for the second data storage circuit 244B after performing data output operations for the first data storage circuit 243B are described as follows.

At time T11, the first data control circuit 310B may generate the output control pulse OCP including a pulse that is generated to have the voltage level of the first internal voltage VPERI when the output control signal OCTR is enabled.

The edge sensing circuit 320B may generate the rising output enable signal OEN that is generated to have the voltage level of the first internal voltage VPERI when the level of the output control pulse OCP transitions from a logic low level to a logic high level.

At time T12, the edge sensing circuit 320B may generate the falling output enable signal OENF that is generated to have the voltage level of the first internal voltage VPERI when the level of the output control pulse OCP transitions from a logic high level to a logic low level.

The second data receiver 410B may generate the rising internal control signal ICTR having the voltage level of the first internal voltage VPERI by delaying the rising output enable signal OEN that has the voltage level of the first internal voltage VPERI and has been generated at time T11.

At time T13, the second data receiver 410B may generate the falling internal control signal ICTF having the voltage level of the first internal voltage VPERI by delaying the falling output enable signal OENF that has the voltage level of the first internal voltage VPERI and has been generated at time T12.

The internal pulse generation circuit 420B may generate the rising internal pulse IPR having the voltage level of the first internal voltage VPERI by delaying the rising internal control signal ICTR that has the voltage level of the first internal voltage VPERI and has been generated at time T12.

At time T14, the internal pulse generation circuit 420B may generate the falling internal pulse IPF having the voltage level of the first internal voltage VPERI by delaying the falling internal control signal ICTF that has the voltage level of the first internal voltage VPERI and has been generated at time T13.

The delay output enable signal generation circuit 430B may convert the voltage level of the rising internal pulse IPR that has the voltage level of the first internal voltage VPERI and has been generated at time T13 into the voltage level of the second internal voltage VGIO and may generate the rising delay output enable signal OEND having the voltage level of the second internal voltage VGIO by delaying the rising internal pulse IPR.

When the rising delay output enable signal OEND is input to have the second internal voltage VGIO during an interval in which the enable interval signal ENT is enabled to a logic high level, the first data receiver 330B may generate the rising driving signal RDRV that is generated to have the voltage level of the first internal voltage VPERI.

At time T15, the delay output enable signal generation circuit 430B may convert the voltage level of the falling internal pulse IPF that has the voltage level of the first internal voltage VPERI and has been generated at time T14 into the voltage level of the second internal voltage VGIO and may generate the falling delay output enable signal OENFD having the voltage level of the second internal voltage VGIO by delaying the falling internal pulse IPF.

When the falling delay output enable signal OENFD is input to have the second internal voltage VGIO during the interval in which the enable interval signal ENT is enabled to a logic high level, the first data receiver 330B may generate the falling driving signal FDRV that is generated to have the voltage level of the first internal voltage VPERI.

The first data receiver 330B may generate the data control signal DCTR that is generated to have the voltage level of the first internal voltage VPERI by synthesizing the rising driving signal RDRV that is generated to have the voltage level of the first internal voltage VPERI and the falling driving signal FDRV that is generated to have the voltage level of the first internal voltage VPERI.

At time T16, the repeater enable signal generation circuit 340B may generate the repeater enable signal RPEN that is generated to have the voltage level of the first internal voltage VPERI by delaying the data control signal DCTR that has generated at time T15 by a delay amount that is adjusted by the delay code DCD<1:N>.

The repeater 350B may generate the output data OUTD by driving the input and output line IO based on the logic level of the first internal data ID1 when the repeater enable signal RPEN is enabled. The repeater 350B may output the output data OUTD to the data input and output circuit 250A through the input and output line IO.

At time T17, the first data control circuit 310B may generate the output control pulse OCP including a pulse that is generated to have the voltage level of the first internal voltage VPERI when the output control signal OCTR is enabled.

The edge sensing circuit 320B may generate the rising output enable signal OEN that is generated to have the voltage level of the first internal voltage VPERI when the level of the output control pulse OCP transitions from a logic low level to a logic high level.

At time T18, the edge sensing circuit 320B may generate the falling output enable signal OENF that is generated to have the voltage level of the first internal voltage VPERI when the level of the output control pulse OCP transitions from a logic high level to a logic low level.

The second data receiver 410B may generate the rising internal control signal ICTR having the voltage level of the first internal voltage VPERI by delaying the rising output enable signal OEN that has the voltage level of the first internal voltage VPERI and has been generated at time T17.

At time T19, the second data receiver 410B may generate the falling internal control signal ICTF having the voltage level of the first internal voltage VPERI by delaying the falling output enable signal OENF that has the voltage level of the first internal voltage VPERI and has been generated at time T18.

The internal pulse generation circuit 420B may generate the rising internal pulse IPR having the voltage level of the first internal voltage VPERI by delaying the rising internal control signal ICTR that has the voltage level of the first internal voltage VPERI and has been generated at time T18.

At time T20, the internal pulse generation circuit 420B may generate the falling internal pulse IPF having the voltage level of the first internal voltage VPERI by delaying the falling internal control signal ICTF that has the voltage level of the first internal voltage VPERI and has been generated at time T19.

The delay output enable signal generation circuit 430B may convert the voltage level of the rising internal pulse IPR that has the voltage level of the first internal voltage VPERI and has been generated at time T19 into the voltage level of the second internal voltage VGIO and may generate the rising delay output enable signal OEND having the voltage level of the second internal voltage VGIO by delaying the rising internal pulse IPR.

The first data receiver 330B may generate the rising driving signal RDRV that is generated to have the voltage level of the first internal voltage VPERI when the rising delay output enable signal OEND is input to have the second internal voltage VGIO during an interval in which the enable interval signal ENT is enabled to a logic high level.

At time T21, the delay output enable signal generation circuit 430B may convert the voltage level of the falling internal pulse IPF that has the voltage level of the first internal voltage VPERI and has been generated at time T20 into the voltage level of the second internal voltage VGIO and may generate the falling delay output enable signal OENFD having the voltage level of the second internal voltage VGIO by delaying the falling internal pulse IPF.

When the falling delay output enable signal OENFD is input to have the second internal voltage VGIO during the interval in which the enable interval signal ENT is enabled to a logic high level, the first data receiver 330B may generate the falling driving signal FDRV that is generated to have the voltage level of the first internal voltage VPERI.

The first data receiver 330B may generate the data control signal DCTR that is generated to have the voltage level of the first internal voltage VPERI, by synthesizing the rising driving signal RDRV that is generated to have the voltage level of the first internal voltage VPERI and the falling driving signal FDRV that is generated to have the voltage level of the first internal voltage VPERI.

At time T22, the repeater enable signal generation circuit 340B may generate the repeater enable signal RPEN that is generated to have the voltage level of the first internal voltage VPERI by delaying the data control signal DCTR that has been generated at time T21 by a delay amount that is adjusted by the delay code DCD<1:N>.

The repeater 350B may generate the output data OUTD by driving the input and output line IO based on the logic level of the second internal data ID2 when the repeater enable signal RPEN is enabled. The repeater 350B may output the output data OUTD to the data input and output circuit 250A through the input and output line IO.

The memory device 20B according to an embodiment of the present disclosure can secure a margin between data and an enable signal because the data are output by compensating for a delay due to an aggregate distance traveled by the enable signals that activate the repeater 350B and a voltage difference between the heterogeneous power supplies VPERI and VGIO. The memory device 20B can prevent an error occurring in data because the data are output by compensating for a delay due to an aggregate distance traveled by the enable signals that activate the repeater 350B and the voltage difference between the heterogeneous power supplies VPERI and VGIO.

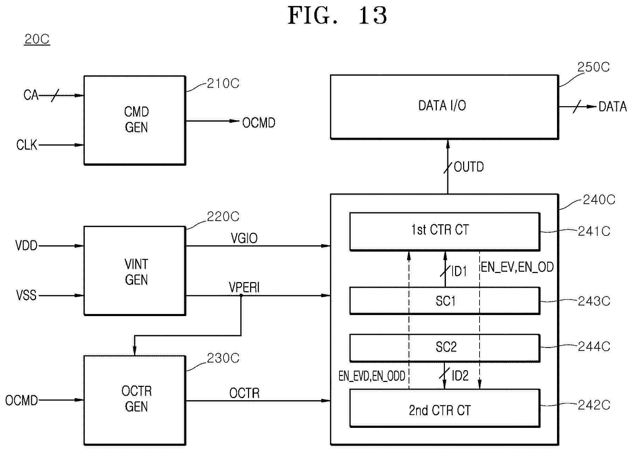

FIG. 13 is a block diagram illustrating a construction according to an embodiment of the memory device 20 included in the semiconductor system 1. The memory device 20C may include a command generation circuit (CMD GEN) 210C, an internal voltage generation circuit (VINT GEN) 220C, an output control signal generation circuit (OCTR GEN) 230C, a memory circuit 240C, and a data input and output circuit (DATA I/O) 250C.

The command generation circuit 210C may generate an output command OCMD that is enabled when the command address CA that is input in synchronization with the clock CLK has a logic level combination for performing a data output operation. The command generation circuit 210C may be implemented to generate the output command OCMD; however, the command generation circuit 210C may be implemented to generate a command for controlling various operations, such as an active operation, data storage operation, and precharge operation of the memory device 20C.

The internal voltage generation circuit 220C may generate a first internal voltage VPERI and a second internal voltage VGIO by being supplied with a power supply voltage VDD and a ground voltage VSS that are supplied from an external source. The internal voltage generation circuit 220C may be implemented with a common voltage generation circuit and may generate the first internal voltage VPERI and the second internal voltage VGIO by lowering the voltage level of the power supply voltage VDD that is supplied from the external source. The first internal voltage VPERI may be set as a voltage having a higher voltage level than the second internal voltage VGIO.

The output control signal generation circuit 230C may be supplied with the first internal voltage VPERI. The output control signal generation circuit 230B may generate an output control signal OCTR that is enabled when the output command OCMD is input. The output control signal generation circuit 230C may generate the output control signal OCTR that is driven to the voltage level of the first internal voltage VPERI when the output command OCMD is input.

The memory circuit 240C may include a first control circuit (1^{st} CTR CT) 241C, a second control circuit (2n CTR CT) 242C, a first data storage circuit (SC1) 243C, and a second data storage circuit (SC2) 244C.

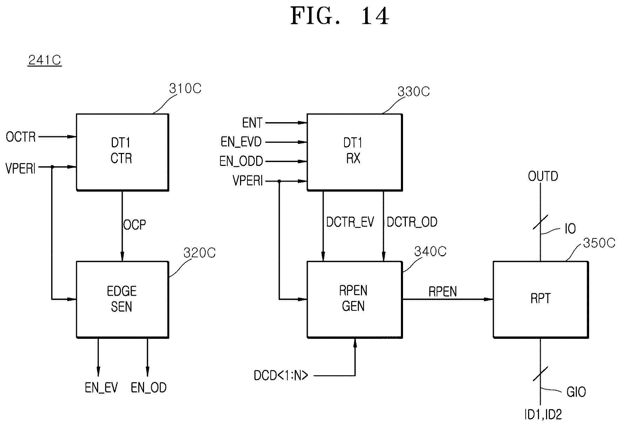

The first control circuit 241C may be disposed to be adjacent to the data input and output circuit 250C. The first control circuit 241C may be supplied with the first internal voltage VPERI and the second internal voltage VGIO. The first control circuit 241C may generate an even output enable signal EN_EV and an odd output enable signal EN_OD that are driven to the first internal voltage VPERI, based on an output control pulse OCP as shown in FIG. 14, which is generated when the output control signal OCTR is enabled, after the start of a data output operation. The first control circuit 241C may generate the even output enable signal EN_EV that are driven to the first internal voltage VPERI by sensing a rising edge of the output control pulse OCP as shown in FIG. 14, which is generated when the output control signal OCTR is enabled, after the start of a first data output operation. The first control circuit 241C may generate the odd output enable signal EN_OD by sensing a rising edge of the output control pulse OCP as shown in FIG. 14, which is generated when the output control signal OCTR is enabled, after the start of a second data output operation. The first control circuit 241C may generate the even output enable signal EN_EV that is driven to the first internal voltage VPERI by sensing a rising edge of the output control pulse OCP as shown in FIG. 14, which is generated when the output control signal OCTR is enabled, after the start of a third data output operation. The first control circuit 241C may generate the odd output enable signal EN_OD by sensing a rising edge of the output control pulse OCP as shown in FIG. 14, which is generated when the output control signal OCTR is enabled, after the start of a fourth data output operation. The first data output operation, the second data output operation, the third data output operation, and the fourth data output operation mean data output operations that are sequentially performed. The first control circuit 241C may output the even output enable signal EN_EV and the odd output enable signal EN_OD to the second control circuit 242C. The first control circuit 241C may receive, from the second control circuit 242C, an even delay output enable signal EN_EVD and an odd delay output enable signal EN_ODD that are driven to the second internal voltage VGIO. The first control circuit 241C may activate a repeater (RPT) 350C as shown in FIG. 14, by receiving the even delay output enable signal EN_EVD and the odd delay output enable signal EN_ODD. The first control circuit 241C may generate output data OUTD from internal data ID1 and ID2 loaded onto a global line GIO as shown in FIG. 14, through the repeater 350C as shown in FIG. 14, and may output the output data to the data input and output circuit 250C. The first control circuit 241C may adjust a timing at which the repeater 350C as shown in FIG. 14, is activated by compensating for an aggregate distance of a distance that the even output enable signal EN_EV and the odd output enable signal EN_OD travel and a distance that the even delay output enable signal EN_EVD and the odd delay output enable signal EN_ODD travel and a voltage difference between the first internal voltage VPERI and the second internal voltage VGIO.

The aggregate distance may be set as the sum of a distance that the even output enable signal EN_EV and the odd output enable signal EN_OD travel when output from the first control circuit 241C to the first data storage circuit 243C, the second data storage circuit 244C, and the second control circuit 242C and a distance that the even delay output enable signal EN_EVD and the odd delay output enable signal EN_ODD travel when output from the second control circuit 242C to the second data storage circuit 244C, the first data storage circuit 243C, and the first control circuit 241C.

The second control circuit 242C may be disposed to be adjacent to the second data storage circuit 244C. The second control circuit 242C may be supplied with the first internal voltage VPERI and the second internal voltage VGIO. The second control circuit 242C may generate the even delay output enable signal EN_EVD and the odd delay output enable signal EN_ODD based on the even output enable signal EN_EV and the odd output enable signal EN_OD after the start of a data output operation. The second control circuit 242C may generate the even delay output enable signal EN_EVD and the odd delay output enable signal EN_ODD that are driven to the second internal voltage VGIO, based on the even output enable signal EN_EV and the odd output enable signal EN_OD. The second control circuit 242C may output the even delay output enable signal EN_EVD and the odd delay output enable signal EN_ODD to the first control circuit 241C. The second control circuit 242C may be disposed to be spaced apart from the data input and output circuit 250C with the first control circuit 241C, the first data storage circuit 243C, and the second data storage circuit 244C interspersed therebetween. The second control circuit 242C may output the second internal data ID2 that are output by the second data storage circuit 244C to the global line GIO as shown in FIG. 14, when the output control signal OCTR is enabled.

The first data storage circuit 243C may be disposed to be adjacent to the first control circuit 241C. The first data storage circuit 243C may output the first internal data ID1 that are stored in the first data storage circuit 243C through the global line GIO as shown in FIG. 14, after the start of the first data output operation and the third data output operation. The first data storage circuit 243C may be implemented to perform a data output operation; however, the first data storage circuit 243C may also be implemented with a common data storage circuit that stores the first internal data ID1 in a plurality of memory cells after the start of a data storage operation.

The second data storage circuit 244C may be disposed to be adjacent to the first data storage circuit 243C. The second data storage circuit 244C may output the second internal data ID2 that are stored in the second data storage circuit 244C through the global line GIO as shown in FIG. 14, after the start of the second data output operation and the fourth data output operation. The second data storage circuit 244C may be implemented to perform a data output operation; however, the second data storage circuit 244C may also be implemented with a common data storage circuit that stores the second internal data ID2 in a plurality of memory cells after the start of a data storage operation.

The data input and output circuit 250C may receive the output data OUTD from the first control circuit 241C after the start of the first data output operation, the second data output operation, the third data output operation, and the fourth data output operation. The data input and output circuit 250C may generate the data DATA from the output data OUTD after the start of the first data output operation, the second data output operation, the third data output operation, and the fourth data output operation. The data input and output circuit 250C may output the data DATA to the controller 10.

The first internal data ID1, the second internal data ID2, the output data OUTD, and the data DATA according to an embodiment of the present disclosure may each be generated to have the voltage level of the ground voltage VSS or the second internal voltage VGIO. A case in which the first internal data ID1, the second internal data ID2, the output data OUTD, and the data DATA are each generated to have the voltage level of the ground voltage VSS may correspond to a case in which each of the first internal data ID1, the second internal data ID2, the output data OUTD, and the data DATA is in a logic low level. A case in which the first internal data ID1, the second internal data ID2, the output data OUTD, and the data DATA are each generated to have the voltage level of the second internal voltage VGIO may correspond to a case in which each of the first internal data ID1, the second internal data ID2, the output data OUTD, and the data DATA is in a logic high level.

The memory device 20C may perform the first data output operation, the second data output operation, the third data output operation, and the fourth data output operation based on the command address CA that is input in synchronization with the clock CLK. The memory device 20C may generate the even output enable signal EN_EV that is driven to the first internal voltage VPERI by sensing an edge at which the level of the output control pulse OCP as shown in FIG. 14, transitions after the start of the first data output operation and the third data output operation. The memory device 20C may generate the odd output enable signal EN_OD that is driven to the first internal voltage VPERI by sensing an edge at which the level of the output control pulse OCP as shown in FIG. 14, transitions after the start of the second data output operation and the fourth data output operation. The memory device 20C may adjust a timing at which the repeater 350B as shown in FIG. 14, is activated by compensating for an aggregate distance including a distance that the even output enable signal EN_EV and the odd output enable signal EN_OD travel and a distance that the even delay output enable signal EN_EVD and the odd delay output enable signal EN_ODD travel and a voltage difference between the first internal voltage VPERI and the second internal voltage VGIO. The memory device 20C may generate the output data OUTD from the internal data ID1 and ID2 loaded onto the global line GIO as shown in FIG. 14, when the repeater 350C as shown in FIG. 14, is activated after the start of the first data output operation, the second data output operation, the third data output operation, and the fourth data output operation. The memory device 20C may generate the data DATA from the output data OUTD after the start of the first data output operation, the second data output operation, the third data output operation, and the fourth data output operation. The memory device 20C may output the data DATA to the controller 10.

FIG. 14 is a block diagram illustrating an example of the first control circuit 241C included in the memory device 20C. The first control circuit 241C may include a first data control circuit (DT1 CTR) 310C, an edge sensing circuit (EDGE SEN) 320C, a first data receiver (DT1 RX) 330C, a repeater enable signal generation circuit (RPEN GEN) 340C, and the repeater (RPT) 350C.

The first data control circuit 310C may be supplied with the first internal voltage VPERI. The first data control circuit 310C may generate the output control pulse OCP including a pulse that is generated based on the output control signal OCTR. The first data control circuit 310C may generate the output control pulse OCP including a pulse that is generated whenever the output control signal OCTR is enabled. For example, if the first data output operation is performed, the first data control circuit 310C may generate a first pulse of the output control pulse OCP when the output control signal OCTR is enabled for the first time after the start of the first data output operation. If the first data output operation and the second data output operation are consecutively performed, the first data control circuit 310C may generate a second pulse of the output control pulse OCP after a first pulse of the output control pulse OCP is generated when the output control signal OCTR is enabled for the second time. If the first data output operation, the second data output operation, and the third data output operation are consecutively performed, the first data control circuit 310C may generate a second pulse of the output control pulse OCP after a first pulse of the output control pulse OCP is generated and generate a third pulse of the output control pulse OCP after the second pulse of the output control pulse OCP is generated, when the output control signal OCTR is enabled for the third time. If the first data output operation, the second data output operation, the third data output operation, and the fourth data output operation are consecutively performed, the first data control circuit 310C may generate a second pulse of the output control pulse OCP after a first pulse of the output control pulse OCP is generated, generate a third pulse of the output control pulse OCP after the second pulse of the output control pulse OCP is generated, and generate a fourth pulse of the output control pulse OCP after the third pulse of the output control pulse OCP is generated, when the output control signal OCTR is enabled for the fourth time. The first data control circuit 310C may generate the output control pulse OCP including a pulse that is generated to have the voltage level of the first internal voltage VPERI whenever the output control signal OCTR is enabled.

The edge sensing circuit 320C may be supplied with the first internal voltage VPERI. The edge sensing circuit 320B may generate the even output enable signal EN_EV and the odd output enable signal EN_OD by detecting an edge at which the level of the output control pulse OCP transitions. The edge sensing circuit 320C may generate the even output enable signal EN_EV by sensing a rising edge at which the level of a first pulse of the output control pulse OCP transitions from a logic low level to a logic high level. The edge sensing circuit 320C may generate the even output enable signal EN_EV that is generated to have the voltage level of the first internal voltage VPERI when the level of the first pulse of the output control pulse OCP transitions from a logic low level to a logic high level. The edge sensing circuit 320C may generate the odd output enable signal EN_OD by sensing a rising edge at which the level of a second pulse of the output control pulse OCP transitions from a logic low level to a logic high level. The edge sensing circuit 320C may generate the odd output enable signal EN_OD that is generated to have the voltage level of the first internal voltage VPERI when the level of the second pulse of the output control pulse OCP transitions from a logic low level to a logic high level. The edge sensing circuit 320C may generate the even output enable signal EN_EV by sensing a rising edge at which the level of a third pulse of the output control pulse OCP transitions from a logic low level to a logic high level. The edge sensing circuit 320C may generate the even output enable signal EN_EV that is generated to have the voltage level of the first internal voltage VPERI when the level of the third pulse of the output control pulse OCP transitions from a logic low level to a logic high level. The edge sensing circuit 320C may generate the odd output enable signal EN_OD by sensing a rising edge at which the level of a fourth pulse of the output control pulse OCP transitions from a logic low level to a logic high level. The edge sensing circuit 320C may generate the odd output enable signal EN_OD that is generated to have the voltage level of the first internal voltage VPERI when the level of the fourth pulse of the output control pulse OCP transitions from a logic low level to a logic high level.

The first data receiver 330C may be supplied with the first internal voltage VPERI. The first data receiver 330C may generate an even data control signal DCTR_EV and an odd data control signal DCTR_OD based on the even delay output enable signal EN_EVD and the odd delay output enable signal EN_ODD that are driven to the second internal voltage VGIO during an interval in which an enable interval signal ENT is enabled. The first data receiver 330C may generate the even data control signal DCTR_EV that is generated to have the voltage level of the first internal voltage VPERI when the even delay output enable signal EN_EVD is input to have the second internal voltage VGIO during the interval in which the enable interval signal ENT is enabled. The first data receiver 330C may generate the odd data control signal DCTR_OD that is generated to have the voltage level of the first internal voltage VPERI when the odd delay output enable signal EN_ODD is input to have the second internal voltage VGIO during an interval in which the enable interval signal ENT is enabled.

The repeater enable signal generation circuit 340C may be supplied with the first internal voltage VPERI. The repeater enable signal generation circuit 340C may generate a repeater enable signal RPEN by delaying any one of the even data control signal DCTR_EV and the odd data control signal DCTR_OD by a delay amount that is adjusted by a delay code DCD<1:N>. The repeater enable signal generation circuit 340C may generate the repeater enable signal RPEN that is generated to have the voltage level of the first internal voltage VPERI by delaying any one of the even data control signal DCTR_EN and the odd data control signal DCTR_OD by a delay amount that is adjusted by the delay code DCD<1:N>. The delay code DCD<1:N> may be generated to have various logic level combinations for adjusting the aggregate distance. The delay code DCD<1:N> may be set as a signal that is input from the controller 10 or a circuit, such as a mode register set (MRS) included in the memory device 20C.

The repeater 350C may be activated when the repeater enable signal RPEN is enabled. The repeater 350C may generate the output data OUTD from the first internal data ID1 or the second internal data ID2 loaded onto the global line GIO when the repeater enable signal RPEN is enabled. The repeater 350C may generate the output data OUTD by driving the input and output line IO based on the logic level of the first internal data ID1 or the second internal data ID2 when the repeater enable signal RPEN is enabled. The repeater 350C may output the output data OUTD to the data input and output circuit 250C through an input and output line IO. The first internal data ID1, the second internal data ID2, and the output data OUTD may each be set as common data including a plurality of bits.

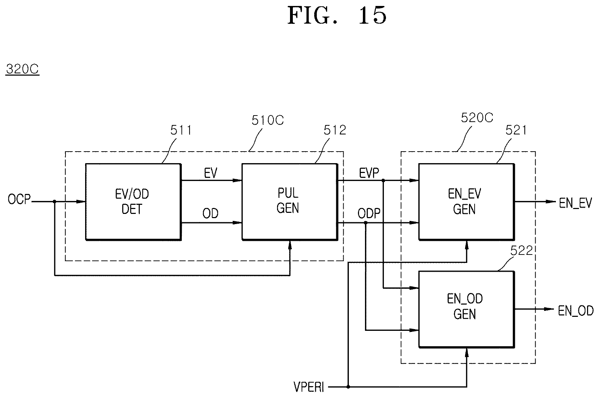

FIG. 15 is a block diagram illustrating an example of the edge sensing circuit 320C included in the first control circuit 241C. The edge sensing circuit 320C may include an even odd sensing circuit 510C and an output enable signal generation circuit 520C.

The even odd sensing circuit 510C may include an even odd detection signal generation circuit (EV/ODD DET) 511 and a pulse signal generation circuit (PUL GEN) 512.

The even odd detection signal generation circuit 511 may generate an even detection signal EV and an odd detection signal OD based on a pulse of the output control pulse OCP. The even odd detection signal generation circuit 511 may generate the even detection signal EV that is enabled to the voltage level of the first internal voltage VPERI when the level of a first pulse of the output control pulse OCP transitions. The even odd detection signal generation circuit 511 may generate the odd detection signal OD that is enabled to the voltage level of the first internal voltage VPERI when the level of a second pulse of the output control pulse OCP transitions. The even odd detection signal generation circuit 511 may generate the even detection signal EV that is enabled to the voltage level of the first internal voltage VPERI when the level of a third pulse of the output control pulse OCP transitions. The even odd detection signal generation circuit 511 may generate the odd detection signal OD that is enabled to the voltage level of the first internal voltage VPERI when the level of a fourth pulse of the output control pulse OCP transitions.

The pulse signal generation circuit 512 may generate an even pulse signal EVP and an odd pulse signal ODP, based on the even detection signal EV, the odd detection signal OD, and the output control pulse OCP. The pulse signal generation circuit 512 may generate the even pulse signal EVP based on the output control pulse OCP during an interval in which the even detection signal EV is enabled. The pulse signal generation circuit 512 may generate the even pulse signal EVP when a first pulse of the output control pulse OCP is generated during an interval in which the even detection signal EV is enabled. The pulse signal generation circuit 512 may generate the even pulse signal EVP when a third pulse of the output control pulse OCP is generated during an interval in which the even detection signal EV is enabled. The pulse signal generation circuit 512 may generate the odd pulse signal ODP based on the output control pulse OCP during an interval in which the odd detection signal OD is enabled. The pulse signal generation circuit 512 may generate the odd pulse signal ODP when a second pulse of the output control pulse OCP is generated during an interval in which the odd detection signal OD is enabled. The pulse signal generation circuit 512 may generate the odd pulse signal ODP when a fourth pulse of the output control pulse OCP is generated during an interval in which the odd detection signal OD is enabled.

The output enable signal generation circuit 520C may include an even output enable signal generation circuit (EN_EV GEN) 521 and an odd output enable signal generation circuit (EN_OD GEN) 522.

The even output enable signal generation circuit 521 may be supplied with the first internal voltage VPERI. The even output enable signal generation circuit 521 may generate the even output enable signal EN_EV based on the even pulse signal EVP and the odd pulse signal ODP. The even output enable signal generation circuit 521 may generate the even output enable signal EN_EV that is enabled from a timing at which the even pulse signal EVP is enabled to a timing at which the odd pulse signal ODP is enabled. The even output enable signal generation circuit 521 may generate the even output enable signal EN_EV that is driven to the voltage level of the first internal voltage VPERI from a timing at which the even pulse signal EVP is enabled to a timing at which the odd pulse signal ODP is enabled.

The odd output enable signal generation circuit 522 may be supplied with the first internal voltage VPERI. The odd output enable signal generation circuit 522 may generate the odd output enable signal EN_OD based on the odd pulse signal ODP and the even pulse signal EVP. The odd output enable signal generation circuit 522 may generate the odd output enable signal EN_OD from a timing at which the odd pulse signal ODP is enabled to a timing at which the even pulse signal EVP is enabled. The even output enable signal generation circuit 521 may generate the odd output enable signal EN_OD that is driven to the voltage level of the first internal voltage VPERI from a timing at which the odd pulse signal ODP is enabled to a timing at which the even pulse signal EVP is enabled.

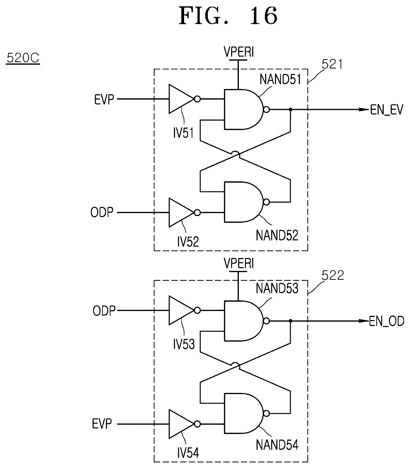

FIG. 16 is a circuit diagram illustrating an example of the even output enable signal generation circuit 521 and the odd output enable signal generation circuit 522 that are included in the output enable signal generation circuit 520C.

The even output enable signal generation circuit 521 may be implemented with inverters IV51 and IV52 and NAND gates NAND51 and NAND52. The even output enable signal generation circuit 521 may be supplied with the first internal voltage VPERI. The even output enable signal generation circuit 521 may generate the even output enable signal EN_EV that is driven to the voltage level of the first internal voltage VPERI when the even pulse signal EVP is enabled to a logic high level. The even output enable signal generation circuit 521 may generate the even output enable signal EN_EV that is driven to the voltage level of the ground voltage VSS when the odd pulse signal ODP is enabled to a logic high level. The even output enable signal generation circuit 521 may generate the even output enable signal EN_EV that is enabled from a timing at which the even pulse signal EVP is enabled to a logic high level to a timing at which the odd pulse signal ODP is enabled to a logic high level.

The odd output enable signal generation circuit 522 may be implemented with inverters IV53 and IV54 and NAND gates NAND53 and NAND54. The odd output enable signal generation circuit 522 may be supplied with the first internal voltage VPERI. The odd output enable signal generation circuit 522 may generate the odd output enable signal EN_OD that is driven to the voltage level of the first internal voltage VPERI when the odd pulse signal ODP is enabled to a logic high level. The odd output enable signal generation circuit 522 may generate the odd output enable signal EN_OD that is driven to the voltage level of the ground voltage VSS when the even pulse signal EVP is enabled to a logic high level. The odd output enable signal generation circuit 522 may generate the odd output enable signal EN_OD that is enabled from a timing at which the odd pulse signal ODP is enabled to a logic high level to a timing at which the even pulse signal EVP is enabled to a logic high level.

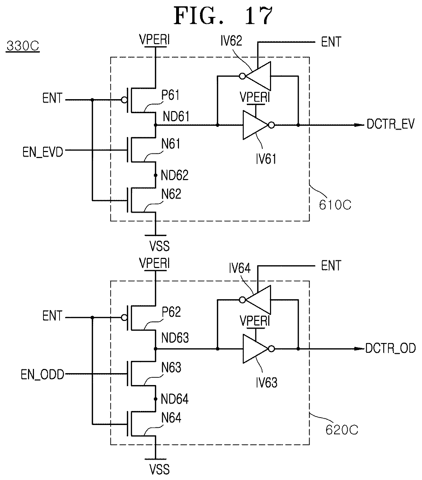

FIG. 17 is a circuit diagram illustrating an example of the first data receiver 330C included in the first control circuit 241C. The first data receiver 330C may include a first driving circuit 610C and a second driving circuit 620C.

The first driving circuit 610C may be implemented with a PMOS transistor P61 that is disposed between the first internal voltage VPERI and a node ND61 and that drives the node ND61 to the first internal voltage VPERI when the enable interval signal ENT is disabled to a logic low level. The first driving circuit 610C may be implemented with an NMOS transistor N61 that is disposed between the node ND61 and a node ND62 and that discharges the charges of the node ND61 when the even delay output enable signal EN_EVD is input to have the second internal voltage VGIO. The first driving circuit 610C may be implemented with an NMOS transistor N62 that is disposed between the node ND62 and the ground voltage VSS and that discharges the charges of the node ND62 to the ground voltage VSS when the enable interval signal ENT is enabled to a logic high level. The first driving circuit 610C may be implemented with inverters IV61 and IV62 that are supplied with the first internal voltage VPERI, generating the even data control signal DCTR_EV that is generated to have the voltage level of the first internal voltage VPERI when the node ND61 is driven to the ground voltage VSS and latching the voltage level of the node ND61 when the enable interval signal ENT is enabled to a logic high level.

The first driving circuit 610C may be supplied with the first internal voltage VPERI. The first driving circuit 610C may generate the even data control signal DCTR_EV that is disabled to a logic low level when the enable interval signal ENT is disabled to a logic low level. When the enable interval signal ENT is enabled to a logic high level and the even delay output enable signal EN_EVD that is driven to the second internal voltage VGIO is enabled, the first driving circuit 610C may generate the even data control signal DCTR_EV that is enabled to have the first internal voltage VPERI by driving the node ND61.

The second driving circuit 620C may be implemented with a PMOS transistor P62 that is disposed between the first internal voltage VPERI and a node ND63 and that drives the node ND63 to the first internal voltage VPERI when the enable interval signal ENT is disabled to a logic low level. The second driving circuit 620C may be implemented with an NMOS transistor N63 that is disposed between the node ND63 and a node ND64 and that discharges the charges of the node ND63 when the odd delay output enable signal EN_ODD is input to have the second internal voltage VGIO. The second driving circuit 620C may be implemented with an NMOS transistor N64 that is disposed between the node ND64 and the ground voltage VSS and that discharges the charges of the node ND64 to the ground voltage VSS when the enable interval signal ENT is enabled to a logic high level. The second driving circuit 620C may be implemented with inverters IV63 and IV64 that are supplied with the first internal voltage VPERI, generating the odd data control signal DCTR_OD that is generated to have the voltage level of the first internal voltage VPERI when the node ND63 is driven to the ground voltage VSS and latching the voltage level of the node ND63 when the enable interval signal ENT is enabled to a logic high level.

The second driving circuit 620C may be supplied with the first internal voltage VPERI. The second driving circuit 620C may generate the odd data control signal DCTR_OD that is disabled to a logic low level when the enable interval signal ENT is disabled to a logic low level. When the enable interval signal ENT is enabled to a logic high level and the odd delay output enable signal EN_ODD that is driven to the second internal voltage VGIO is enabled, the second driving circuit 620C may generate the odd data control signal DCTR_OD that is enabled to the first internal voltage VPERI by driving the node ND63.

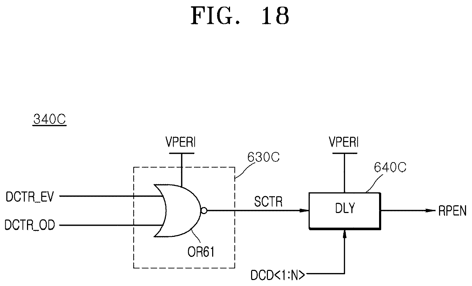

FIG. 18 is a diagram illustrating an example of the repeater enable signal generation circuit 340C included in the first control circuit 241C. The repeater enable signal generation circuit 340C may include a signal synthesis circuit 630C and a delay circuit (DLY) 640C.

The signal synthesis circuit 630C may be implemented with an OR gate OR61. The signal synthesis circuit 630C may be supplied with the first internal voltage VPERI. The signal synthesis circuit 630C may generate a synthesis output enable signal SCTR by synthesizing the even data control signal DCTR_EV and the odd data control signal DCTR_OD. When any one of the even data control signal DCTR_EV and the odd data control signal DCTR_OD is enabled, the signal synthesis circuit 630C may generate the synthesis output enable signal SCTR that is enabled to have the first internal voltage VPERI.

The delay circuit 640C may be supplied with the first internal voltage VPERI. The delay circuit 640C may generate the repeater enable signal RPEN by delaying the synthesis output enable signal SCTR by a delay amount that is adjusted by the delay code DCD<1:N>. The delay circuit 640C may generate the repeater enable signal RPEN that is generated to have the voltage level of the first internal voltage VPERI, by delaying the synthesis output enable signal SCTR by a delay amount that is adjusted by the delay code DCD<1:N>. The delay code DCD<1:N> may be generated to have various logic level combinations for adjusting the aggregate distance. The delay code DCD<1:N> may be set as a signal that is input from the controller 10 or a circuit, such as a mode register set (MRS) included in the memory device 20C.

The repeater enable signal generation circuit 340C may be supplied with the first internal voltage VPERI. The repeater enable signal generation circuit 340C may generate the repeater enable signal RPEN by delaying any one of the even data control signal DCTR_EV and the odd data control signal DCTR_OD by a delay amount that is adjusted by the delay code DCD<1:N>.

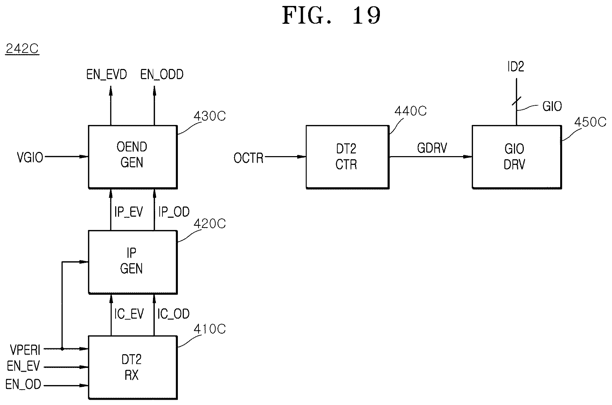

FIG. 19 is a block diagram illustrating an example of the second control circuit 242C included in included in the memory device 20C. The second control circuit 242C may include a second data receiver (DT2 RX) 410C, an internal pulse generation circuit (IP GEN) 420C, a delay output enable signal generation circuit (OEND GEN) 430C, a second data control circuit (DT2 CTR) 440C, and a global input and output line driver (GIO DRV) 450C.

The second data receiver 410C may be supplied with the first internal voltage VPERI. The second data receiver 410C may generate an even internal control signal IC_EV and an odd internal control signal IC_OD based on the even output enable signal EN_EV and the odd output enable signal EN_OD. The second data receiver 410C may generate the even internal control signal IC_EV that is generated to have the voltage level of the first internal voltage VPERI when the even output enable signal EN_EV is input to have the first internal voltage VPERI. The second data receiver 410C may generate the even internal control signal IC_EV having the voltage level of the first internal voltage VPERI by delaying the even output enable signal EN_EV having the voltage level of the first internal voltage VPERI. The second data receiver 410C may generate the odd internal control signal IC_OD that is generated to have the voltage level of the first internal voltage VPERI when the odd output enable signal EN_OD is input to have the first internal voltage VPERI. The second data receiver 410C may generate the odd internal control signal IC_OD having the voltage level of the first internal voltage VPERI by delaying the odd output enable signal EN_OD having the voltage level of the first internal voltage VPERI.

The internal pulse generation circuit 420C may be supplied with the first internal voltage VPERI. The internal pulse generation circuit 420C may generate an even internal pulse IP_EV and an odd internal pulse IP_OD based on the even internal control signal IC_EV and the odd internal control signal IC_OD. The internal pulse generation circuit 420C may generate the even internal pulse IP_EV that is generated to have the voltage level of the first internal voltage VPERI when the even internal control signal IC_EV is input to have the first internal voltage VPERI. The internal pulse generation circuit 420C may generate the even internal pulse IP_EV having the voltage level of the first internal voltage VPERI by delaying the even internal control signal IC_EV having the voltage level of the first internal voltage VPERI. The internal pulse generation circuit 420C may generate the odd internal pulse IP_OD that is generated to have the voltage level of the first internal voltage VPERI when the odd internal control signal IC_OD is input to have the first internal voltage VPERI. The internal pulse generation circuit 420C may generate the odd internal pulse IP_OD having the voltage level of the first internal voltage VPERI by delaying the odd internal control signal IC_OD having the voltage level of the first internal voltage VPERI.

The delay output enable signal generation circuit 430C may be supplied with the second internal voltage VGIO. The delay output enable signal generation circuit 430C may generate the even delay output enable signal EN_EVD and the odd delay output enable signal EN_ODD based on the even internal pulse IP_EV and the odd internal pulse IP_OD. The delay output enable signal generation circuit 430C may generate the even delay output enable signal EN_EVD that is generated to have the voltage level of the second internal voltage VGIO when the even internal pulse IP_EV is input to have the first internal voltage VPERI. The delay output enable signal generation circuit 430C may convert the voltage level of the even internal pulse IP_EV having the voltage level of the first internal voltage VPERI into the voltage level of the second internal voltage VGIO and may generate the even delay output enable signal EN_EVD having the voltage level of the second internal voltage VGIO by delaying the even internal pulse IP_EV. The delay output enable signal generation circuit 430C may generate the odd delay output enable signal EN_ODD that is generated to have the voltage level of the second internal voltage VGIO when the odd internal pulse IP_OD is input to have the first internal voltage VPERI. The delay output enable signal generation circuit 430C may convert the voltage level of the odd internal pulse IP_OD having the voltage level of the first internal voltage VPERI into the voltage level of the second internal voltage VGIO and may generate the odd delay output enable signal EN_ODD having the voltage level of the second internal voltage VGIO by delaying the odd internal pulse IP_OD.

The second data control circuit 440C may generate a driving signal GDRV including a pulse that is generated based on the output control signal OCTR. The second data control circuit 440C may generate the driving signal GDRV including a pulse that is generated when the output control signal OCTR is enabled. The second data control circuit 440C may generate the driving signal GDRV including a pulse that is generated when the output control signal OCTR is generated to have the voltage level of the first internal voltage VPERI.

The global input and output line driver 450C may be turned on when a pulse of the driving signal GDRV is input. The global input and output line driver 450C may output the second internal data ID2 that are output by the second data storage circuit 244B to the global input and output line GIO when a pulse of the driving signal GDRV is input.

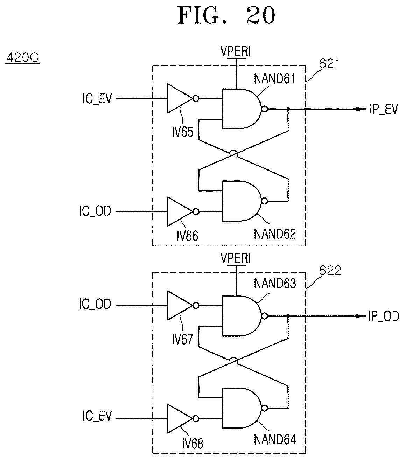

FIG. 20 is a circuit diagram illustrating an example of the internal pulse generation circuit 420C included in the second control circuit 242C. The internal pulse generation circuit 420C may include an even internal pulse generation circuit 621 and an odd internal pulse signal 622.

The even internal pulse generation circuit 621 may be implemented with inverters IV65 and IV66 and NAND gates NAND61 and NAND62. The even internal pulse generation circuit 621 may be supplied with the first internal voltage VPERI. The even internal pulse generation circuit 621 may generate the even internal pulse IP_EV that is driven to the voltage level of the first internal voltage VPERI when the even internal control signal IC_EV is enabled to a logic high level. The even internal pulse generation circuit 621 may generate the even internal pulse IP_EV that is driven to the voltage level of the ground voltage VSS when the odd internal control signal IC_OD is enabled to a logic high level. The even internal pulse generation circuit 621 may generate the even internal pulse IP_EV that is enabled from a timing at which the even internal control signal IC_EV is enabled to a logic high level to a timing at which the odd internal control signal IC_OD is enabled to a logic high level.

The odd internal pulse signal 622 may be implemented with inverters IV67 and IV68 and NAND gates NAND63 and NAND64. The odd internal pulse signal 622 may be supplied with the first internal voltage VPERI. The odd internal pulse signal 622 may generate the odd internal pulse IP_OD that is driven to the voltage level of the first internal voltage VPERI when the odd internal control signal IC_OD is enabled to a logic high level. The odd internal pulse signal 622 may generate the odd internal pulse IP_OD that is driven to the voltage level of the ground voltage VSS when the even internal control signal IC_EV is enabled to a logic high level. The odd internal pulse signal 622 may generate the odd internal pulse IP_OD that is enabled from a timing at which the odd internal control signal IC_OD is enabled to a logic high level to a timing at which the even internal control signal IC_EV is enabled to a logic high level.

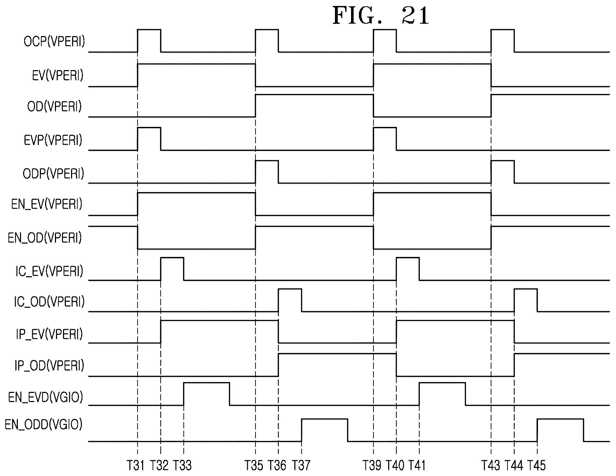

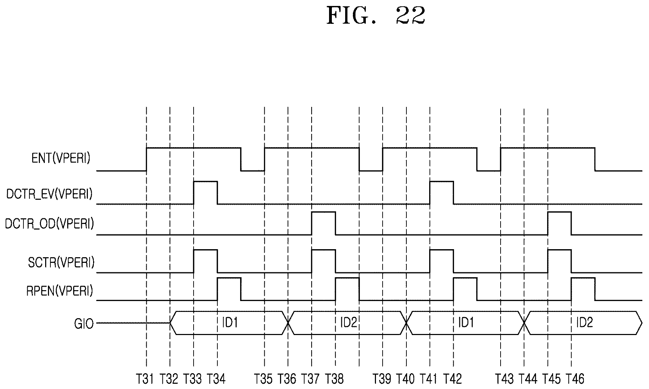

FIGS. 21 and 22 are timing diagrams for describing an operation of the memory device 20C according to an embodiment of the present disclosure. First to fourth data output operations of the memory device 20C are described with reference to FIGS. 21 and 22. In this case, an operation of performing a second data output operation for the second data storage circuit 244B after performing a first data output operation for the first data storage circuit 243B and performing a fourth data output operation for the second data storage circuit 244B after performing a third data output operation for the first data storage circuit 243B is described as follows.

At time T31, the first data control circuit 310C may generate a first pulse of the output control pulse OCP that is generated to have the voltage level of the first internal voltage VPERI when the output control signal OCTR is enabled after the start of a first data output operation.

The even odd detection signal generation circuit 511 of the edge sensing circuit 320C may generate the even detection signal EV that is enabled to the voltage level of the first internal voltage VPERI when the level of the first pulse of the output control pulse OCP transitions. The pulse signal generation circuit 512 of the edge sensing circuit 320C may generate the even pulse signal EVP that is generated to have the voltage level of the first internal voltage VPERI based on the output control pulse OCP during an interval in which the even detection signal EV is enabled. The even output enable signal generation circuit 521 of the edge sensing circuit 320C may generate the even output enable signal EN_EV that is enabled to the voltage level of the first internal voltage VPERI when the even pulse signal EVP is enabled.

At time T32, the second data receiver 410C may generate the even internal control signal IC_EV that is generated to have the voltage level of the first internal voltage VPERI when the even output enable signal EN_EV is input to have the first internal voltage VPERI.

The internal pulse generation circuit 420C may generate the even internal pulse IP_EV that is generated to have the voltage level of the first internal voltage VPERI when the even internal control signal IC_EV is input to have the first internal voltage VPERI.

At time T33, the delay output enable signal generation circuit 430C may convert the voltage level of the even internal pulse IP_EV having the voltage level of the first internal voltage VPERI into the voltage level of the second internal voltage VGIO and may generate the even delay output enable signal EN_EVD having the voltage level of the second internal voltage VGIO by delaying the even internal pulse IP_EV generated at time T32.

The first data receiver 330C may generate the even data control signal DCTR_EV that is generated to have the voltage level of the first internal voltage VPERI when the even delay output enable signal EN_EVD is input to have the second internal voltage VGIO during the interval in which the enable interval signal ENT is enabled.

The signal synthesis circuit 630C of the repeater enable signal generation circuit 340C may generate the synthesis output enable signal SCTR that is enabled to the first internal voltage VPERI when the even data control signal DCTR_EV is enabled.

At time T34, the delay circuit 640C may generate the repeater enable signal RPEN that is generated to have the voltage level of the first internal voltage VPERI by delaying the synthesis output enable signal SCTR by a delay amount that is adjusted by the delay code DCD<1:N>.

The repeater 350C may generate the output data OUTD by driving the input and output line IO based on the logic level of the first internal data ID1 when the repeater enable signal RPEN is enabled. The repeater 350C may output the output data OUTD to the data input and output circuit 250C through the input and output line IO.

At time T35, the first data control circuit 310C may generate the second pulse of the output control pulse OCP that is generated to have the voltage level of the first internal voltage VPERI when the output control signal OCTR is enabled after the start of a second data output operation.

The even odd detection signal generation circuit 511 of the edge sensing circuit 320C may generate the odd detection signal OD that is enabled to the voltage level of the first internal voltage VPERI when the level of a second pulse of the output control pulse OCP transitions. The pulse signal generation circuit 512 of the edge sensing circuit 320C may generate the odd pulse signal ODP that is generated to have the voltage level of the first internal voltage VPERI based on the output control pulse OCP during an interval in which the odd detection signal OD is enabled. The odd output enable signal generation circuit 522 of the edge sensing circuit 320C may generate the odd output enable signal EN_OD that is enabled to the voltage level of the first internal voltage VPERI when the odd pulse signal ODP is enabled.

At time T36, the second data receiver 410C may generate the odd internal control signal IC_OD that is generated to have the voltage level of the first internal voltage VPERI when the odd output enable signal EN_OD is input to have the first internal voltage VPERI.

The internal pulse generation circuit 420C may generate the odd internal pulse IP_OD that is generated to have the voltage level of the first internal voltage VPERI when the odd internal control signal IC_OD is input to have the first internal voltage VPERI.

At time T37, the delay output enable signal generation circuit 430C may convert the voltage level of the odd internal pulse IP_OD having the voltage level of the first internal voltage VPERI into the voltage level of the second internal voltage VGIO and may generate the odd delay output enable signal EN_ODD having the voltage level of the second internal voltage VGIO by delaying the odd internal pulse IP_OD generated at time T36.

The first data receiver 330C may generate the odd data control signal DCTR_OD that is generated to have the voltage level of the first internal voltage VPERI when the odd delay output enable signal EN_ODD is input to have the second internal voltage VGIO during an interval in which the enable interval signal ENT is enabled.

The signal synthesis circuit 630C of the repeater enable signal generation circuit 340C may generate the synthesis output enable signal SCTR that is enabled to the first internal voltage VPERI when the odd data control signal DCTR_OD is enabled.

At time T38, the delay circuit 640C may generate the repeater enable signal RPEN that is generated to have the voltage level of the first internal voltage VPERI by delaying the synthesis output enable signal SCTR by a delay amount that is adjusted by the delay code DCD<1:N>.

The repeater 350C may generate the output data OUTD by driving the input and output line IO based on the logic level of the second internal data ID2 when the repeater enable signal RPEN is enabled. The repeater 350C may output the output data OUTD to the data input and output circuit 250C through the input and output line IO.

At time T39, the first data control circuit 310C may generate a third pulse of the output control pulse OCP that is generated to have the voltage level of the first internal voltage VPERI when the output control signal OCTR is enabled after the start of a third data output operation.

The even odd detection signal generation circuit 511 of the edge sensing circuit 320C may generate the even detection signal EV that is enabled to the voltage level of the first internal voltage VPERI when the level of the third pulse of the output control pulse OCP transitions. The pulse signal generation circuit 512 of the edge sensing circuit 320C may generate the even pulse signal EVP that is generated to have the voltage level of the first internal voltage VPERI based on the output control pulse OCP during an interval in which the even detection signal EV is enabled. The even output enable signal generation circuit 521 of the edge sensing circuit 320C may generate the even output enable signal EN_EV that is enabled to the voltage level of the first internal voltage VPERI when the even pulse signal EVP is enabled.

At time T40, the second data receiver 410C may generate the even internal control signal IC_EV that is generated to have the voltage level of the first internal voltage VPERI when the even output enable signal EN_EV is input to have the first internal voltage VPERI.

The internal pulse generation circuit 420C may generate the even internal pulse IP_EV that is generated to have the voltage level of the first internal voltage VPERI when the even internal control signal IC_EV is input to have the first internal voltage VPERI.

At time T41, the delay output enable signal generation circuit 430C may convert the voltage level of the even internal pulse IP_EV having the voltage level of the first internal voltage VPERI into the voltage level of the second internal voltage VGIO and may generate the even delay output enable signal EN_EVD having the voltage level of the second internal voltage VGIO by delaying the even internal pulse IP_EV generated at time T40.

The first data receiver 330C may generate the even data control signal DCTR_EV that is generated to have the voltage level of the first internal voltage VPERI when the even delay output enable signal EN_EVD is input to have the second internal voltage VGIO during an interval in which the enable interval signal ENT is enabled.

The signal synthesis circuit 630C of the repeater enable signal generation circuit 340C may generate the synthesis output enable signal SCTR that is enabled to the first internal voltage VPERI when the even data control signal DCTR_EV is enabled.

At time T42, the delay circuit 640C may generate the repeater enable signal RPEN that is generated to have the voltage level of the first internal voltage VPERI by delaying the synthesis output enable signal SCTR by a delay amount that is adjusted by the delay code DCD<1:N>.

The repeater 350C may generate the output data OUTD by driving the input and output line IO based on the logic level of the first internal data ID1 when the repeater enable signal RPEN is enabled. The repeater 350C may output the output data OUTD to the data input and output circuit 250C through the input and output line IO.

At time T43, the first data control circuit 310C may generate a fourth pulse of the output control pulse OCP that is generated to have the voltage level of the first internal voltage VPERI when the output control signal OCTR is enabled after the start of a fourth data output operation.

The even odd detection signal generation circuit 511 of the edge sensing circuit 320C may generate the odd detection signal OD that is enabled to the voltage level of the first internal voltage VPERI when the level of the fourth pulse of the output control pulse OCP transitions. The pulse signal generation circuit

512 of the edge sensing circuit 320C may generate the odd pulse signal ODP that is generated to have the voltage level of the first internal voltage VPERI based on the output control pulse OCP during an interval in which the odd detection signal OD is enabled. The odd output enable signal generation circuit 522 of the edge sensing circuit 320C may generate the odd output enable signal EN_OD that is enabled to the voltage level of the first internal voltage VPERI when the odd pulse signal ODP is enabled.

At time T44, the second data receiver 410C may generate the odd internal control signal IC_OD that is generated to have the voltage level of the first internal voltage VPERI when the odd output enable signal EN_OD is input to have the first internal voltage VPERI.

The internal pulse generation circuit 420C may generate the odd internal pulse IP_OD that is generated to have the voltage level of the first internal voltage VPERI when the odd internal control signal IC_OD is input to have the first internal voltage VPERI.

At time T45, the delay output enable signal generation circuit 430C may convert the voltage level of the odd internal pulse IP_OD having the voltage level of the first internal voltage VPERI into the voltage level of the second internal voltage VGIO and may generate the odd delay output enable signal EN_ODD having the voltage level of the second internal voltage VGIO by delaying the odd internal pulse IP_OD generated at time T44.

The first data receiver 330C may generate the odd data control signal DCTR_OD that is generated to have the voltage level of the first internal voltage VPERI when the odd delay output enable signal EN_ODD is input to have the second internal voltage VGIO during an interval in which the enable interval signal ENT is enabled.

The signal synthesis circuit 630C of the repeater enable signal generation circuit 340C may generate the synthesis output enable signal SCTR that is enabled to the first internal voltage VPERI when the odd data control signal DCTR_OD is enabled.

At time T46, the delay circuit 640C may generate the repeater enable signal RPEN that is generated to have the voltage level of the first internal voltage VPERI by delaying the synthesis output enable signal SCTR by a delay amount that is adjusted by the delay code DCD<1:N>.

The repeater 350C may generate the output data OUTD by driving the input and output line IO based on the logic level of the second internal data ID2 when the repeater enable signal RPEN is enabled. The repeater 350C outputs the output data OUTD to the data input and output circuit 250C through the input and output line IO.

The memory device 20C according to an embodiment of the present disclosure can secure a margin between data and an enable signal by compensating for a delay due to an aggregate distance traveled by the enable signals that activate the repeater 350C, and a voltage difference between the heterogeneous power supplies VPERI and VGIO. The memory device 20C can prevent an error occurring in data because the data are output by compensating for a delay due to an aggregate distance traveled by the enable signals that activate the repeater 350C and the voltage difference between the heterogeneous power supplies VPERI and VGIO.

## Claims

1. A memory device comprising:
a first control circuit disposed to be adjacent to a data input and output circuit, configured to:
generate an output enable signal that is driven to a first internal voltage based on an output control pulse that is generated after a start of a data output operation;
generate output data from internal data loaded onto a global line through a repeater by receiving a delay output enable signal that is driven to a second internal voltage; and
output the output data to the data input and output circuit;
a data storage circuit disposed to be adjacent to the first control circuit and configured to output the internal data to the global line after the start of the data output operation; and
a second control circuit disposed to be adjacent to the data storage circuit and configured to generate the delay output enable signal based on the output enable signal after the start of the data output operation.

2. The memory device of claim 1, wherein the first control circuit adjusts a timing at which the repeater is activated by compensating for an aggregate distance that the output enable signal travels and a distance that the delay output enable signal travels and a voltage difference between the first internal voltage and the second internal voltage.

3. The memory device of claim 2, wherein the aggregate distance is set as a sum of a distance that the output enable signal travels when output from the first control circuit to the data storage circuit and the second control circuit and a distance that the delay output enable signal travels when output from the second control circuit to the data storage circuit and the first control circuit.

4. The memory device of claim 1, wherein the second control circuit is disposed to be spaced apart from the data input and output circuit with the first control circuit and the data storage circuit interspersed therebetween.

5. The memory device of claim 1, wherein the first internal voltage is a voltage that is generated to have a higher voltage level than the second internal voltage.

6. The memory device of claim 1, wherein the internal data is generated to have a voltage level of a ground voltage or the second internal voltage.

7. The memory device of claim 1, wherein the first control circuit comprises:
a first data control circuit supplied with the first internal voltage and configured to generate the output control pulse comprising a pulse that is generated based on an output control signal that is generated after the start of the data output operation;
an edge sensing circuit supplied with the first internal voltage and configured to generate the output enable signal by sensing an edge at which a level of the output control pulse transitions;
a first data receiver supplied with the first internal voltage and configured to generate a data control signal based on the delay output enable signal that is driven to the second internal voltage;
a repeater enable signal generation circuit supplied with the first internal voltage and configured to generate a repeater enable signal by delaying the data control signal by a delay amount that is adjusted by a delay code; and
the repeater configured to generate the output data from the internal data loaded onto the global line when the repeater enable signal is enabled and configured to output the output data to the data input and output circuit.

8. The memory device of claim 1, wherein the second control circuit comprises:
a second data receiver supplied with the first internal voltage and configured to generate an internal control signal based on the output enable signal;
an internal pulse generation circuit supplied with the first internal voltage and configured to generate an internal pulse comprising a pulse that is generated based on the internal control signal; and
a delay output enable signal generation circuit supplied with the second internal voltage and configured to generate the delay output enable signal that is driven to the second internal voltage by adjusting a voltage level of the internal pulse.

9. A memory device comprising:
a first control circuit disposed to be adjacent to a data input and output circuit and configured to:
generate a rising output enable signal and a falling output enable signal that are driven to a first internal voltage by sensing an edge at which a level of an output control pulse that is generated after a start of a data output operation transitions;
receive a rising delay output enable signal and a falling delay output enable signal that are driven to a second internal voltage;
generate output data from internal data loaded onto a global line through a repeater; and
output the output data to the data input and output circuit;
a data storage circuit disposed to be adjacent to the first control circuit and configured to output the internal data to the global line after the start of the data output operation; and
a second control circuit disposed to be adjacent to the data storage circuit and configured to generate the rising delay output enable signal and the falling delay output enable signal based on the rising output enable signal and the falling output enable signal after the start of the data output operation.

10. The memory device of claim 9, wherein the first control circuit adjusts a timing at which the repeater is activated by compensating for an aggregate distance that the rising output enable signal and the falling output enable signal travel and a distance that the rising delay output enable signal and the falling delay output enable signal travel and a voltage difference between the first internal voltage and the second internal voltage.

11. The memory device of claim 9,
wherein the first control circuit is configured to generate the rising output enable signal that is driven to the first internal voltage by sensing a rising edge of the output control pulse, and
wherein the first control circuit is configured to generate the falling output enable signal that is driven to the first internal voltage by sensing a falling edge of the output control pulse.

12. The memory device of claim 9, wherein the first control circuit comprises:
a first data control circuit supplied with the first internal voltage and configured to generate the output control pulse comprising a pulse that is generated based on an output control signal after the start of the data output operation;
an edge sensing circuit supplied with the first internal voltage and configured to generate the rising output enable signal and the falling output enable signal by sensing an edge at which a level of the output control pulse transitions;
a first data receiver supplied with the first internal voltage and configured to generate a data control signal based on the rising delay output enable signal and the falling delay output enable signal that are driven to the second internal voltage;
a repeater enable signal generation circuit supplied with the first internal voltage and configured to generate a repeater enable signal by delaying the data control signal by a delay amount that is adjusted by a delay code; and
the repeater configured to generate the output data from the internal data loaded onto the global line when the repeater enable signal is enabled and configured to output the output data to the data input and output circuit.

13. The memory device of claim 12, wherein the first data receiver comprises:
a first driving circuit supplied with the first internal voltage and configured to generate a rising driving signal by driving a first node when an enable interval signal and the rising delay output enable signal that is driven to the second internal voltage are enabled;
a second driving circuit supplied with the first internal voltage and configured to generate a falling driving signal by driving a second node when the enable interval signal and the falling delay output enable signal that is driven to the second internal voltage are enabled; and
a signal synthesis circuit supplied with the first internal voltage and configured to generate the data control signal by synthesizing the rising driving signal and the falling driving signal.

14. The memory device of claim 9, wherein the second control circuit comprises:
a second data receiver supplied with the first internal voltage and configured to generate a rising internal control signal and a falling internal control signal based on the rising output enable signal and the falling output enable signal;
an internal pulse generation circuit supplied with the first internal voltage and configured to generate a rising internal pulse and a falling internal pulse each comprising a pulse that is generated based on the rising internal control signal and the falling internal control signal; and
a delay output enable signal generation circuit supplied with the second internal voltage and configured to generate the rising delay output enable signal and the falling delay output enable signal that are driven to the second internal voltage by adjusting voltage levels of the rising internal pulse and the falling internal pulse.

15. A memory device comprising:
a first control circuit disposed to be adjacent to a data input and output circuit and configured to generate an even output enable signal and an odd output enable signal that are driven to a first internal voltage based on an output control pulse that is generated after a start of first and second data output operations that are consecutively performed, configured to receive an even delay output enable signal and an odd delay output enable signal that are driven to a second internal voltage, configured to sequentially generate first and second output data from first and second internal data loaded onto a global line through a repeater, and configured to output the first and second output data to the data input and output circuit;
a data storage circuit disposed to be adjacent to the first control circuit and configured to output the internal data to the global line after the start of the data output operation; and
a second control circuit disposed to be adjacent to the data storage circuit and configured to generate the even delay output enable signal based on the even output enable signal after the start of the first data output operation and configured to generate the odd delay output enable signal based on the odd output enable signal after the start of the second data output operation.

16. The memory device of claim 15, wherein:
the first data output operation is performed when an output command is input for a first time and for a third time, and
the second data output operation is performed when the output command is input for a second time and for a fourth time.

17. The memory device of claim 15, wherein the first control circuit adjusts a timing at which the repeater is activated by compensating for an aggregate distance that the even output enable signal and the odd output enable signal travel and a distance that the even delay output enable signal and the odd delay output enable signal travel and a voltage difference between the first internal voltage and the second internal voltage.

18. The memory device of claim 17, wherein the aggregate distance is set as a sum of a distance that the even output enable signal and the odd output enable signal travel when output from the first control circuit to the data storage circuit and the second control circuit and a distance that the even delay output enable signal and the odd delay output enable signal travel when output from the second control circuit to the data storage circuit and the first control circuit.

19. The memory device of claim 15, wherein the first control circuit comprises:
a first data control circuit supplied with the first internal voltage and configured to generate the output control pulse comprising first and second pulses that are generated based on an output control signal that is generated after the start of the first and second data output operations;
an edge sensing circuit supplied with the first internal voltage and configured to generate the even output enable signal by sensing an edge at which a level of a first pulse of the output control pulse transitions and configured to generate the odd output enable signal by sensing an edge at which a level of a second pulse of the output control pulse transitions;
a first data receiver supplied with the first internal voltage and configured to generate an even data control signal and an odd data control signal based on the even delay output enable signal and the odd delay output enable signal that are driven to the second internal voltage;
a repeater enable signal generation circuit supplied with the first internal voltage and configured to generate a repeater enable signal by delaying any one of the even data control signal and the odd data control signal by a delay amount that is adjusted by a delay code; and
a repeater configured to generate the output data from the first and second internal data loaded onto the global line when the repeater enable signal is enabled and configured to output the output data to the data input and output circuit.

20. The memory device of claim 19, wherein the edge sensing circuit comprises:
an even odd sensing circuit configured to generate an even pulse signal by sensing an edge at which a level of a first pulse of the output control pulse transitions and configured to generate an odd pulse signal by sensing an edge at which a level of a second pulse of the output control pulse transitions; and
an output enable signal generation circuit supplied with the first internal voltage and configured to generate the even output enable signal and the odd output enable signal each comprising a pulse that is selectively generated based on the even pulse signal and the odd pulse signal.

21. The memory device of claim 20, wherein the even odd sensing circuit comprises:
an even odd detection signal generation circuit configured to generate an even detection signal that is enabled when the level of the first pulse of the output control pulse transitions and configured to generate an odd detection signal that is enabled when the level of the second pulse of the output control signal transitions; and
a pulse signal generation circuit configured to generate the even pulse signal based on the first pulse of the output control pulse during an interval in which the even detection signal is enabled and configured to generate the odd pulse signal based on the second pulse of the output control pulse during an interval in which the odd detection signal is enabled.

22. The memory device of claim 20, wherein the output enable signal generation circuit comprises:
an even output enable signal generation circuit configured to generate the even output enable signal that is enabled from a timing at which the even pulse signal is enabled to a timing at which the odd pulse signal is enabled; and
an odd output enable signal generation circuit configured to generate the odd output enable signal that is enabled from a timing at which the odd pulse signal is enabled to a timing at which the even pulse signal is enabled.

23. The memory device of claim 19, wherein the repeater enable signal generation circuit comprises:
a signal synthesis circuit supplied with the first internal voltage and configured to generate a synthesis output enable signal by synthesizing the even data control signal and the odd data control signal; and
a delay circuit configured to generate the repeater enable signal by delaying the synthesis output enable signal by the delay amount that is adjusted by the delay code.

24. The memory device of claim 15, wherein the second control circuit comprises:
a second data receiver supplied with the first internal voltage and configured to generate an even internal control signal and an odd internal control signal based on the even output enable signal and the odd output enable signal;
an internal pulse generation circuit supplied with the first internal voltage and configured to generate an even internal pulse and an odd internal pulse each comprising a pulse that is generated based on the even internal control signal and the odd internal control signal; and
a delay output enable signal generation circuit supplied with the second internal voltage and configured to generate the even delay output enable signal and the odd delay output enable signal that are driven to the second internal voltage by adjusting voltage levels of the even internal pulse and the odd internal pulse.

25. The memory device of claim 24, wherein the internal pulse generation circuit comprises:
an even internal pulse generation circuit configured to generate the even internal pulse that is enabled from a timing at which the even internal control signal is enabled to a timing at which the odd internal control signal is enabled; and
an odd internal pulse signal configured to generate the odd internal pulse signal that is enabled from a timing at which the odd internal control signal is enabled to a timing at which the even internal control signal is enabled.
